(19) Europäisches Patentamt
European Patent Office
Office européen des brevets

(11) **EP 4 206 939 A1**

(12) **DEMANDE DE BREVET EUROPEEN**

(43) Date de publication:
**05.07.2023 Bulletin 2023/27**

(21) Numéro de dépôt: **22214972.6**

(22) Date de dépôt: **20.12.2022**

(51) Classification Internationale des Brevets (IPC):
**G06F 12/02** (2006.01)   **G06F 9/345** (2018.01)
**G06F 15/78** (2006.01)   **G06T 1/60** (2006.01)
**G11C 7/10** (2006.01)

(52) Classification Coopérative des Brevets (CPC):
**G06F 15/7821; G06F 12/0207; G06F 12/0284;
G11C 7/1006;** G06F 2212/1024; G06F 2212/454

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **29.12.2021 FR 2114646**

(71) Demandeur: **Commissariat à l'énergie atomique
et aux énergies alternatives
75015 Paris (FR)**

(72) Inventeur: **MAMBU, Kevin
38054 GRENOBLE CEDEX 09 (FR)**

(74) Mandataire: **Cabinet Beaumont
4, Place Robert Schuman
B.P. 1529
38025 Grenoble Cedex 1 (FR)**

(54) **SYSTEME DE TRANSFERT DIRECT DE DONNEES**

(57)    La présente description concerne un système comportant un processeur et un circuit de transfert direct SDMA d'une séquence de données entre un circuit mémoire source et un circuit mémoire destination, une sous-région du circuit source comprenant les éléments d'une matrice de données, le SDMA décodant une information de noyau de calcul dite BIT_PATTERN d'un motif élémentaire de données à transférer défini à partir d'une matrice élémentaire d'une taille prédéfinie inférieure à la taille de ladite matrice de données et destinée à identifier une fenêtre matricielle élémentaire de ladite matrice, chaque élément de la matrice élémentaire comprenant un bit pouvant prendre un état « 1 » ou « 0 » selon que l'élément appartient ou non audit motif, le SDMA récupérant les données de ladite matrice associées à des éléments du BIT_PATTERN dont le bit est à « 1 ».

**Fig. 11**

EP 4 206 939 A1

**Description**

Domaine technique

La présente description concerne de façon générale le domaine des circuits mémoire, et vise plus particulièrement la mise en oeuvre de transferts directs de données vers et depuis un circuit mémoire.

Technique antérieure

On a déjà proposé des circuits mémoire adaptés à mettre en oeuvre des opérations de calcul, ou circuit mémoire "intelligents" (souvent appelé "smart memory" en anglais). De tels circuits sont par exemple destinés à coopérer avec un processeur, de façon à décharger le processeur de certaines tâches de calcul.

Néanmoins, les données utilisées pour les opérations de calcul demandées par un processeur à un tel circuit mémoire ne sont pas toujours présentes dans le circuit mémoire intelligent. En outre, même si elles sont présentes dans le circuit mémoire, elles ne sont pas forcément mémorisées dans un espace souhaité du circuit mémoire, ou selon un ordre de stockage idéal, ce qui peut nécessiter des opérations de manipulation de données dans le circuit mémoire par des lectures/écritures orchestrées par le processeur. Ainsi, il est souhaitable de trouver des solutions pour décharger encore davantage l'utilisation du processeur et de façon générale les canaux d'échange de données utilisés par le processeur.

Plus généralement, dans tout système comprenant un processeur et un circuit mémoire, intelligent ou non, il est souvent nécessaire de réaliser des transferts de données entre le circuit mémoire et un autre dispositif, par exemple un autre circuit mémoire, et éventuellement de réorganiser les données lors du transfert. Là encore, il est souhaitable de trouver des solutions pour décharger l'utilisation du processeur et de façon générale les canaux d'échange de données utilisés par le processeur lors de la mise en oeuvre de tels transferts.

Résumé de l'invention

Un mode de réalisation prévoit un système comportant :

- un processeur ;
- un circuit de transfert direct d'une séquence de données entre un circuit mémoire source et un circuit mémoire destination sans passer par le processeur, une sous-région du circuit mémoire source comprenant une suite d'emplacements consécutifs en terme d'adressage contenant les éléments d'une matrice de données, dans lequel le circuit de transfert direct est adapté à recevoir et décoder une information de noyau de calcul dite BIT_PATTERN d'un motif élémentaire de données à transférer défini à partir d'une matrice élémentaire d'une taille prédéfinie inférieure à la taille de ladite matrice de données et destinée à identifier une fenêtre matricielle élémentaire de ladite matrice, chaque élément de la matrice élémentaire comprenant un bit pouvant prendre un premier ou un deuxième état selon respectivement que l'élément n'appartient pas ou appartient audit motif, la matrice élémentaire du BIT_PATTERN comprenant un élément de référence ; le circuit de transfert direct recevant une adresse source pour un premier motif à transférer, cette adresse source correspondant à l'adresse dans ladite sous-région dudit élément de référence du BIT_PATTERN et correspondant à une donnée de référence de ladite matrice de données située à cette adresse source, les autres éléments du BIT_PATTERN étant associés à d'autres données de ladite matrice par positionnement relatif par rapport respectivement à l'élément de référence du BIT_PATTERN et à la donnée de référence de ladite matrice ; le circuit de transfert direct étant adapté, lors de l'exécution du transfert d'un motif élémentaire, à récupérer les données de ladite matrice associées à des éléments du BIT_PATTERN dont le bit est audit deuxième état.

Selon un mode de réalisation, le système est tel que ledit circuit de transfert direct est adapté à parcourir ladite matrice élémentaire du BIT_PATTERN selon un sens prédéfini en considérant ainsi une suite d'éléments de la matrice élémentaire présentant ledit deuxième état et à transférer successivement les données de la matrice présentes dans le circuit mémoire source et respectivement associées à cette suite d'éléments.

Selon un mode de réalisation, le système est tel que ledit circuit de transfert direct est adapté à écrire, dans le circuit mémoire destination, les données récupérées pour un motif élémentaire autour d'une donnée de référence en les ré-agençant selon un vecteur ligne ou colonne, et le circuit mémoire destination est un circuit mémoire intelligent adapté à mettre en oeuvre des opérations de calcul et à réaliser des opérations élémentaires incluant une lecture ou une écriture de données dans le circuit mémoire ou un calcul à partir de données présentes dans le circuit mémoire.

Selon un mode de réalisation, le système est tel que ladite sous-région est une suite d'emplacements consécutifs en terme d'adressage définis à partir d'une adresse de base BASE_ADDR contenant l'adresse d'une première cellule mémoire de la sous-région, chaque donnée de la matrice présentant une dimension définie par un paramètre EL_SIZE, la largeur des lignes de la matrice étant définie par un paramètre R_WIDTH ; l'adresse d'une donnée de la matrice étant définie par des coordonnées relatives Xpos et Ypos correspondant aux coordonnées, ligne et colonne, dans ladite matrice et à partir de ladite adresse de base BASE_ADDR, et dudit paramètre EL_SIZE, et les données de la matrice sont rangées selon un sens de parcours prédéfini de la matrice.

Selon un mode de réalisation, le système est tel que les coordonnées $S[i].x$, dans la direction des lignes, et $S[i].y$, dans la direction des colonnes, d'un élément de ladite matrice élémentaire associée à un BIT_PATTERN sont définies par des indices positifs ou négatifs autour de coordonnées nulles associées audit élément de référence de la matrice élémentaire, les indices positifs ou négatifs d'une coordonnée d'un élément de la matrice élémentaire étant définis en fonction de ladite matrice de données et dudit sens de parcours prédéfini de ladite matrice élémentaire.

Selon un mode de réalisation, le système est tel que l'adresse Addr(Ax,y) d'une donnée de la matrice est définie selon la formule suivante :

$$\text{Addr}(Ax,y) = \text{BASE\_ADDR} + \text{EL\_SIZE} * (Xpos * R\_WIDTH + YPos),$$

et l'adresse Addr(S[i]) d'une donnée de la matrice correspondant à un élément du BIT_PATTERN à transférer est définie selon la formule suivante :

$$\text{Addr}(S[i]) = \text{BASE\_ADDR} + \text{EL\_SIZE} * (S[i].x * R\_WIDTH + S[i].y).$$

Selon un mode de réalisation, le système est tel que ladite séquence de données comprend plusieurs itérations de transfert d'un même motif élémentaire défini à partir d'un même BIT_PATTERN associé à ladite suite d'éléments de la matrice élémentaire, chaque itération de transfert visant à transférer des données situées respectivement dans plusieurs fenêtres matricielles élémentaires prédéfinies de mêmes dimensions du circuit mémoire source et décalées les unes par rapport aux autres, les décalages étant définis par une suite de décalages d'adresses à partir de l'adresse de la donnée source de la première fenêtre élémentaire , et le circuit de transfert direct est adapté, lors de l'exécution du transfert, à réaliser pour chaque élément de la suite d'éléments, une suite de lecture dans le circuit mémoire source des données correspondant à un même élément de la matrice élémentaire mais situées respectivement dans lesdites plusieurs fenêtres matricielles élémentaires, en définissant les adresses successives des données de cette suite à partir de l'adresse d'une première donnée correspondant à cet élément et associée à une première fenêtre matricielle élémentaire et de ladite suite de décalages et le circuit de transfert est adapté à transférer les données desdites fenêtres matricielles élémentaires en les agençant respectivement selon des vecteurs colonne distincts dans le circuit mémoire destination, une suite de données associées à un même élément de matrice élémentaire du BIT_PATTERN étant écrites dans des emplacement successifs en terme d'adressage de la mémoire destination dans une ou plusieurs lignes de la mémoire destination.

Selon un mode de réalisation, le système est tel que le circuit de transfert direct est adapté à recevoir et décoder les paramètres de transfert suivants :

- SEQ_LEN : le nombre d'itérations du motif élémentaire dans la séquence de données à transférer ;
- SRC_OFFSET : le décalage des adresses sources entre deux itérations successives du motif élémentaire de la séquence de données à transférer ;
- DST_OFFSET : le décalage des adresses d'écriture, dans le circuit mémoire destination entre deux itérations successives du motif élémentaire de la séquence de données à transférer.

Selon un mode de réalisation, le système est tel qu'il comporte au moins un premier et un deuxième circuits mémoire ; et

- le circuit de transfert direct étant adapté à transférer directement des données entre les premier et deuxième circuits mémoire,

  le circuit de transfert direct est adapté à recevoir des instructions spécifiques en provenance d'un processeur externe, et à décoder lesdites instructions et commander en conséquence des transferts de données entre les premier et deuxième circuits,
  lesdites instructions spécifiques comprennent :

  - une instruction spécifique SET_REGION de définition d'une sous-région dans le premier circuit mémoire vers ou depuis laquelle seront transférées les données ; et
- une instruction spécifique de transfert entre ladite sous-région et le deuxième circuit mémoire, l'instruction spécifique de transfert comprenant un premier champ d'adresses contenant les coordonnées relatives, dans ladite sous-région, d'une première cellule de référence,

et le circuit de transfert direct est adapté à exécuter plusieurs instructions de transfert successives vers ou depuis une même sous-région entre deux exécutions d'une instruction SET_REGION.

Un autre mode de réalisation prévoit un système comportant :

- au moins un premier et un deuxième circuits mémoire ; et
- un circuit de transfert direct de données entre les premier et deuxième circuits mémoire,

dans lequel le circuit de transfert direct est adapté à recevoir des instructions spécifiques en provenance d'un processeur externe, et à décoder lesdites instructions et commander en conséquence des transferts de données entre les premier et deuxième circuits,
dans lequel lesdites instructions spécifiques comprennent :

- une instruction spécifique SET_REGION de définition d'une sous-région dans le premier circuit mémoire vers ou depuis laquelle seront transférées les données ; et
- une instruction spécifique de transfert entre ladite sous-région et le deuxième circuit mémoire, l'instruction spécifique de transfert comprenant un premier champ d'adresses contenant les coordonnées relatives, dans ladite sous-région, d'une première cellule de référence,

et dans lequel le circuit de transfert direct est adapté à exécuter plusieurs instructions de transfert successives vers ou depuis une même sous-région entre deux exécutions d'une instruction SET_REGION.

Selon un mode de réalisation du système, le système est tel que :

- ladite sous-région est une suite d'emplacements consécutifs en terme d'adressage dans le premier circuit mémoire, contenant les éléments d'une matrice;
- l'instruction SET_REGION comprend un premier champ contenant l'adresse d'une première cellule mémoire de la sous-région, un deuxième champ contenant la dimension des éléments de la matrice, et un troisième champ contenant la largeur des lignes de la matrice ; et
- ledit premier champ d'adresse de l'instruction de transfert comprend des premier et deuxième sous-champs contenant les coordonnées, ligne et colonne, dans ladite matrice de la première cellule de référence.

Selon un mode de réalisation du système, le système est tel que le deuxième circuit mémoire est un circuit mémoire intelligent adapté à mettre en oeuvre des opérations de calcul et à réaliser des opérations élémentaires incluant une lecture ou une écriture de données dans le circuit mémoire ou un calcul à partir de données présentes dans le circuit mémoire, et le circuit de transfert direct est associé audit deuxième circuit mémoire soit de par son positionnement matériel proche du deuxième circuit mémoire soit de par une configuration du circuit de transfert direct au moyen par exemple d'un registre de configuration du circuit de transfert direct qui est accessible au processeur externe, le circuit de transfert direct connaissant, du fait de cette association, la plage d'adresses système permettant d'accéder au circuit mémoire intelligent via un bus système comprenant un bus d'adresses ; et l'instruction spécifique de transfert comprend un deuxième champ d'adresse contenant les coordonnées relatives, dans cette plage d'adresse système dédiée au circuit mémoire intelligent, d'une deuxième cellule de référence, le nombre de bits du deuxième champ d'adresse étant inférieur à la taille du bus d'adresses.

Selon un mode de réalisation du système, le système est tel qu'il comprend une instruction spécifique READ_TRANSFER de commande d'un transfert d'une séquence de données depuis ladite sous-région du premier circuit mémoire vers le deuxième circuit mémoire intelligent, et comprenant une instruction spécifique WRITE_TRANSFER de commande d'un transfert d'une séquence de données depuis le deuxième circuit mémoire intelligent vers ladite sous-région dans le premier circuit mémoire.

Selon un mode de réalisation du système, le système est tel qu'il comprend un premier jeu de registres d'adressage mémorisant des premières valeurs du premier champ, du deuxième champ et du troisième champ d'une première instruction SET_REGION reçue par le circuit de transfert direct et comprenant en outre un deuxième jeu de registres d'adressage mémorisant des deuxièmes valeurs du premier champ, du deuxième champ et du troisième champ d'une deuxième instruction SET_REGION reçue par le circuit de transfert direct pour définir une deuxième sous-région ; et une instruction spécifique de transfert comprend un deuxième champ d'adresse contenant les coordonnées relatives, dans ladite deuxième sous-région, d'une première cellule de référence dans cette deuxième sous-région.

Selon un mode de réalisation du système, le système est tel que l'instruction spécifique de transfert comprend en outre un quatrième champ définissant un décalage en lecture, dans le premier circuit mémoire source, entre deux itérations consécutives d'un motif élémentaire à transférer, un cinquième champ définissant un décalage en écriture, dans le deuxième circuit mémoire destination, entre deux itérations consécutives du motif élémentaire à transférer, un sixième champ définissant le nombre d'itérations du motif élémentaire à transférer, et un septième champ définissant le motif élémentaire de la séquence à transférer.

Selon un mode de réalisation du système, le système est tel que le circuit de transfert direct comprend une mémoire contenant une pluralité de motifs élémentaires prédéfinis, l'instruction de transfert comprenant un champ contenant un code de sélection de l'un desdits motifs élémentaires prédéfinis.

Selon un mode de réalisation du système, le système est tel que lesdites instructions spécifiques comprennent une instruction spécifique de commande d'un transfert interne de données au sein du même circuit mémoire.

Selon un mode de réalisation du système, le système est tel qu'il comprend une liaison interne d'échange de données reliant directement le deuxième circuit mémoire au circuit de transfert direct.

Selon un mode de réalisation du système, le système est tel qu'il comporte au moins un troisième circuit mémoire, le circuit de transfert direct étant en outre adapté à transférer directement des données entre les premier et troisième circuits mémoire et entre les deuxième et troisième circuits mémoire.

Selon un mode de réalisation du système, le système est tel que le circuit de transfert direct est adapté à transférer une séquence de données entre les premier et deuxième circuits mémoire appelés respectivement circuit mémoire source et circuit mémoire destination, une sous-région du circuit mémoire source comprenant une suite d'emplacements consécutifs en terme d'adressage contenant les éléments d'une matrice de données, le circuit de transfert direct est adapté à recevoir et décoder une information de noyau de calcul dite BIT_PATTERN d'un motif élémentaire de données à transférer défini à partir d'une matrice élémentaire d'une taille prédéfinie inférieure à la taille de ladite matrice de données et destinée à identifier une fenêtre matricielle élémentaire de ladite matrice, chaque élément de la matrice élémentaire comprenant un bit pouvant prendre un premier ou un deuxième état selon respectivement que l'élément n'appartient pas ou appartient audit motif, la matrice élémentaire du BIT_PATTERN comprenant un élément de référence ; le circuit de transfert direct recevant une adresse source pour un premier motif à transférer, cette adresse source correspondant à l'adresse dans ladite sous-région dudit élément de référence du BIT_PATTERN et correspondant à une donnée de référence de ladite matrice de données située à cette adresse source, les autres éléments du BIT_PATTERN étant associés à d'autres données de ladite matrice par positionnement relatif par rapport respectivement à l'élément de référence du BIT_PATTERN et à la donnée de référence de ladite matrice ; le circuit de transfert direct étant adapté, lors de l'exécution du transfert d'un motif élémentaire, à récupérer les données de ladite matrice associées à des éléments du BIT_PATTERN dont le bit est audit deuxième état.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente de façon schématique un exemple d'un circuit mémoire adapté à mettre en oeuvre des opérations de calcul ;

la figure 2 représente de façon schématique un exemple d'un système comportant un module mémoire adapté à mettre en oeuvre des opérations de calcul et un circuit de transfert de données couplé audit module mémoire selon un mode de réalisation ;

la figure 3 illustre plus en détail un exemple d'implémentation du système de la figure 2 ;

la figure 4 représente un exemple de réalisation d'un circuit de transfert de données du module mémoire de la figure 3 ;

la figure 5 illustre schématiquement un exemple d'un traitement pouvant nécessiter une réorganisation des données dans un circuit mémoire ;

la figure 6 illustre un exemple d'agencement des valeurs des pixels d'une image dans un circuit mémoire ;

la figure 7 illustre schématiquement un exemple de format d'un signal d'instruction utilisé par le processeur pour commander le circuit de transfert de données dans le système de la figure 2 ;

la figure 8 illustre schématiquement l'exécution d'une opération de transfert de données dans le système de la figure 2 ;

la figure 9 représente de façon schématique et partielle un exemple d'implémentation d'un circuit de contrôle du circuit de transfert de données du système de la figure 2 ;

la figure 10 représente schématiquement un exemple d'un système de transfert de données selon un mode de réalisation ; et

la figure 11 représente schématiquement le fonctionnement d'un exemple d'un système de transfert selon un mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des différents éléments des modules mémoire et des systèmes décrits n'a pas été détaillée, la réalisation de ces éléments étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

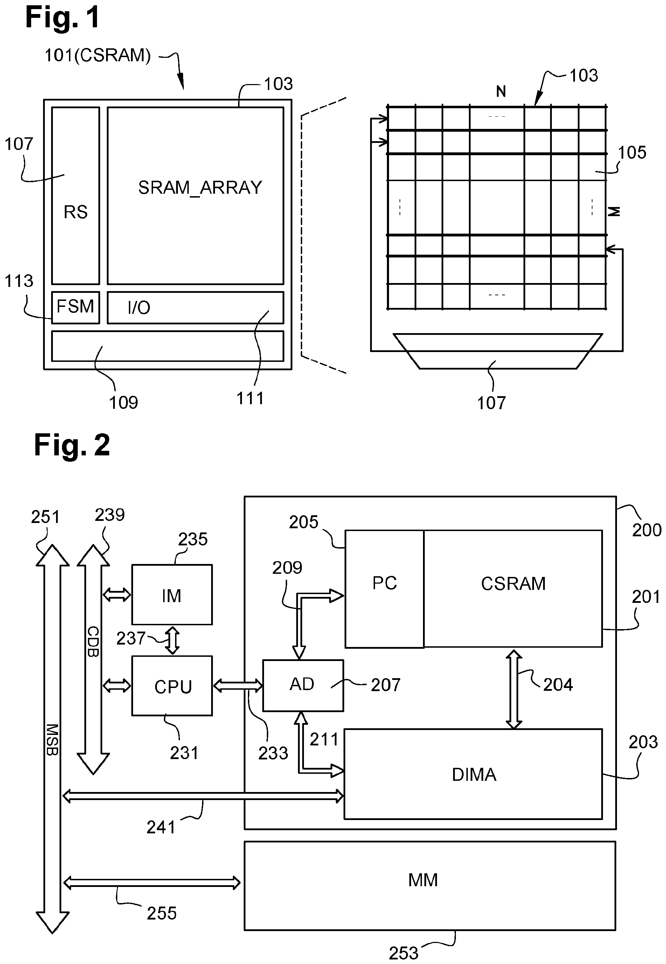

La figure 1 représente de façon schématique un exemple d'un circuit mémoire 101 (CSRAM) adapté à mettre en oeuvre des opérations de calcul. Le circuit 101 comprend une matrice 103 (SRAM_ARRAY) de cellules élémentaires de stockage, par exemple des cellules SRAM (de l'anglais "Static Random Access Memory" - mémoire statique à accès aléatoire). En partie droite de la figure, on a représenté plus en détail certains éléments du circuit mémoire 101, et en particulier la matrice 103 de cellules élémentaires de stockage. Dans cet exemple, la matrice 103 comprend M rangées et N colonnes de cellules élémentaires de stockage 105, avec M et N entiers supérieurs ou égaux à 2. A titre d'exemple, la matrice 103 est similaire aux matrices décrites dans la demande de brevet EP3252774 précédemment déposée par le demandeur.

Le circuit mémoire 101 comprend en outre un circuit de sélection de rangées 107 (RS) adapté à sélectionner une unique rangée de la matrice 103 pour réaliser une opération de lecture ou d'écriture classique. Le circuit de sélection de rangées 107 peut en outre être adapté à sélectionner simultanément en lecture plusieurs rangées de la matrice 103, de façon à mettre en oeuvre, sur des pistes conductrices de sortie de colonne de la matrice, des opérations logiques de base ayant pour opérandes des données stockées dans les rangées sélectionnées.

Le circuit mémoire 101 peut par ailleurs comprendre un circuit de calcul 109 adapté à mettre en oeuvre des opérations de calcul supplémentaires à partir des signaux lus sur les pistes conductrices de sortie de colonne de la matrice 103 et/ou à réécrire directement dans la matrice 103 le résultat d'une opération de calcul, sans passer par des bornes de connexion externes du circuit mémoire 101.

Le circuit mémoire 101 comprend en outre un circuit d'entrée/sortie 111 (I/O) reliant les colonnes de la matrice à des bornes de connexion à l'extérieur du circuit mémoire, par exemple à un port d'entrée/sortie de données (non détaillé sur la figure 1) du circuit mémoire.

Le circuit mémoire de la figure 1 comprend en outre un circuit de contrôle 113 (FSM) relié aux circuits 107, 109 et 111. Le circuit 113 est adapté à décoder et à commander l'exécution d'instructions de lecture, d'écriture et/ou de calcul transmises par un circuit externe de contrôle (non représenté), par exemple un processeur.

La demande de brevet EP3503103 précédemment déposée par le demandeur décrit un exemple d'intégration d'un circuit mémoire adapté à mettre en oeuvre des opérations de calcul dans un système comprenant un processeur. Dans ce système, les accès en lecture et en écriture au circuit mémoire adapté à mettre en oeuvre des opérations de calcul sont effectués par l'intermédiaire du processeur. Ceci peut causer des ralentissements du système lorsque des quantités de données importantes sont transférées depuis ou vers le circuit mémoire adapté à mettre en oeuvre des opérations de calcul.

La figure 2 représente de façon schématique un exemple d'un système comportant un module mémoire 200 adapté à mettre en oeuvre des opérations de calcul selon un mode de réalisation.

Le module mémoire 200 de la figure 2 comprend un circuit mémoire 201 (CSRAM) adapté à mettre en oeuvre des opérations de calcul.

Le circuit mémoire 201 peut être un circuit mémoire de type IMC (de l'anglais "In Memory Computing" - calcul en mémoire), c'est-à-dire dans lequel des calculs sont mis en oeuvre directement au sein de la matrice de cellules élémentaires du circuit mémoire, par exemple tel que décrit en relation avec la figure 1 ou dans la demande de brevet EP3252774 susmentionnée. Plus généralement, le circuit mémoire 201 peut être tout circuit mémoire adapté à mettre en oeuvre des opérations de calcul, par exemple un circuit de type NMC (de l'anglais "Near Memory Computing" - calcul à proximité de la mémoire), c'est-à-dire dans lequel les calculs ne sont pas réalisés directement au sein de la matrice de cellules élémentaires du circuit mémoire, mais dans des circuits de calcul intégrés en périphérie immédiate de la matrice de cellules élémentaires.

Le système de la figure 2 comprend un processeur 231 (CPU) . Plus généralement, le processeur 231 peut être remplacé par tout circuit adapté à générer un flux d'instructions de contrôle. Le système de la figure 2 comprend en outre une mémoire d'instructions 235 (IM) directement reliée au processeur 231 par l'intermédiaire d'une liaison 237. Le processeur 231 et la mémoire d'instructions 235 sont en outre reliés à un même bus système 239 (CDB), aussi appelé bus système processeur ou bus de données processeur ou bus de données CPU ("CPU data bus" en anglais). Le bus 239 peut être un bus du type classiquement utilisé pour échanger des données entre un processeur et des périphériques, par exemple des circuits mémoire, d'un système de traitement de données. Le bus 239 peut notamment comprendre un bus de données, un bus d'adresses et/ou un bus de contrôle. Le bus 239 peut être implémenté au moyen d'un système d'interconnexion distribué de type réseau sur puce ("network on chip" en anglais).

Le module 200 comprend en outre un circuit 203 (DIMA) d'accès direct au circuit 201. Le circuit 203 est relié directement au circuit mémoire 201, par l'intermédiaire d'une liaison de transfert de données 204 interne au module 200. Le circuit 203 est en outre relié directement à un bus système de transfert de données 251 (MSB), aussi appelé bus système mémoire ("memory system bus" en anglais) externe au module 200, par l'intermédiaire d'une liaison 241. Dans cet exemple, le bus système mémoire 251 n'est pas directement connecté au processeur 231. Le bus 251 est un bus spécifiquement dédié au transfert direct (i.e. sans passer par le processeur 231) de données entre le circuit mémoire 201 du module 200 et d'autres circuits périphériques du système, par exemple une mémoire distante, ou toute autre mémoire interne ou externe susceptible d'échanger des données avec le circuit mémoire 201. Le bus 251 peut notamment comprendre un bus de données, un bus d'adresses et/ou un bus de contrôle. Le bus 251 peut être implémenté au moyen d'un système d'interconnexion distribué de type réseau sur puce ("network on chip" en anglais).

On notera que le bus mémoire système 251 et le bus système 239 peuvent avantageusement être reliés l'un à l'autre par différents circuits d'interface. En outre, le bus système 239 et le bus système mémoire 251 peuvent être un même et unique bus, même si cela n'est pas le mode de réalisation préférentiel. En effet, le bus système 239 est souvent de petite taille pour les données et mettre les deux bus en commun pourrait conduire à avoir un bus 251 de petite taille, et de surcroît à augmenter le débit nécessaire sur le bus commun ce qui pourrait en pratique se traduire par une saturation du bus, et par ricochet une diminution du débit d'échanges de données par rapport à une configuration à deux bus.

De préférence, le bus système mémoire 251 est plus large que le bus système processeur 239. La liaison de transfert de données 204 a de préférence une largeur égale à la taille du plus grand vecteur de données pouvant être lu en une fois dans le circuit mémoire 201, par exemple égale à la taille d'une rangée de circuits de lecture présents en pieds de colonnes dans la matrice de cellules élémentaires de stockage du circuit mémoire 201. A titre de variante, la liaison 204 peut avoir une largeur égale à un sous-multiple de la taille du plus grand vecteur de données pouvant être lu en une fois dans le circuit mémoire 201. Le bus 251 peut avoir une largeur égale à la largeur de la liaison 204. A titre de variante, la largeur du bus 251 peut être un sous-multiple de la largeur de la liaison 204. La largeur de la liaison 204 est de préférence supérieure à la largeur d'un port d'entrée/sortie du processeur 231. On notera que par largeur d'un bus, d'un port ou d'une liaison, on entend ici la largeur des données pouvant transiter en parallèle sur le bus, le port ou la liaison (indépendamment d'éventuels signaux additionnels d'adresse et/ou de contrôle).

Le circuit d'accès direct 203 aussi appelé circuit de transfert direct est adapté à transférer des données directement, c'est-à-dire sans faire transiter ces données par le processeur 231, entre le circuit mémoire 201 et le bus système mémoire 251. Dans l'exemple représenté, le système comprend en outre un circuit mémoire 253 (MM) externe au module 200. Le circuit mémoire 253 est relié au bus système mémoire 251 par l'intermédiaire d'une liaison 255. Ainsi, le circuit d'accès direct 203 permet de transférer des données directement, c'est-à-dire sans faire transiter ces données par le processeur 231, entre le circuit mémoire 201 du module 200 et le circuit mémoire externe 253. Plus généralement, le circuit d'accès direct 203 permet de transférer des données directement, c'est-à-dire sans faire transiter ces données par le processeur 231, entre le circuit mémoire 201 du module 200 et tout circuit périphérique connecté au bus système mémoire 251. A titre d'exemple non limitatif, le circuit mémoire 253 peut être une mémoire de type SRAM, une mémoire de type NVM (de l'anglais "Non Volatil Memory" - mémoire non volatile), une mémoire de type DRAM (de l'anglais "Dynamic Random Access Memory" - mémoire dynamique à accès aléatoire), une mémoire de type Flash, ou encore un autre circuit mémoire adapté à mettre en oeuvre des opérations de calcul. Les différents composants du module 200 peuvent être intégrés dans une même puce de circuits intégrés. Le circuit mémoire 253 peut être intégré à cette même puce, ou externe à cette puce.

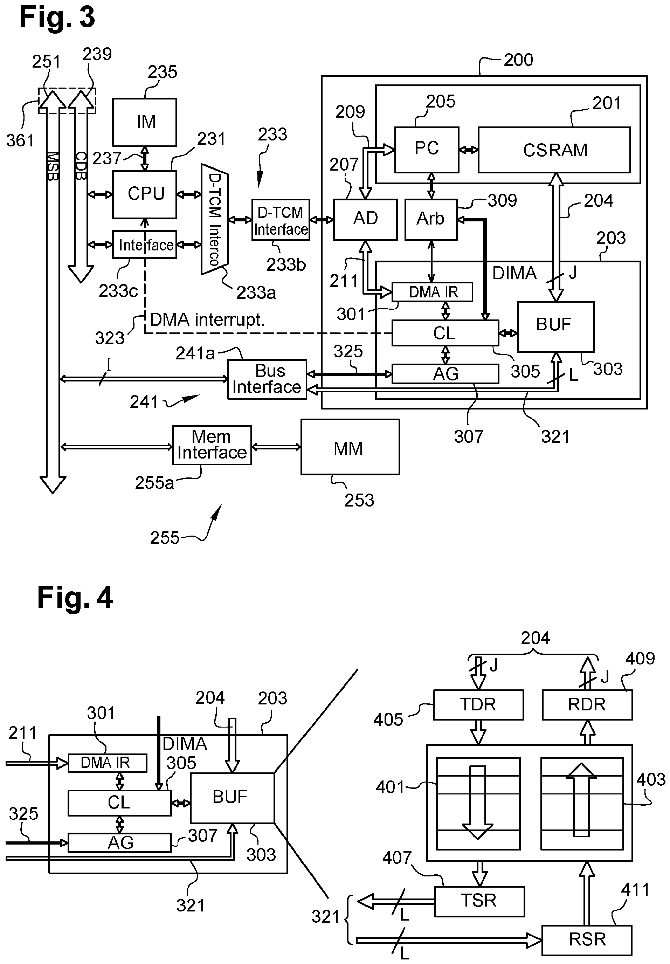

Dans l'exemple de la figure 2, le module 200 comprend en outre un circuit de contrôle 205 (PC pour Pipeline contrôler) adapté à ordonnancer les accès au circuit mémoire 201 requis par le processeur 231. Le circuit 205 est adapté à décoder les instructions reçues en provenance du processeur 231 et à décomposer, si nécessaire, chaque instruction reçue en une séquence de plusieurs sous-opérations aussi appelées opérations élémentaires. Par opération élémentaire, on entend une opération de lecture, d'écriture ou de calcul dans le circuit mémoire 201. Une opération de calcul peut éventuellement consister à actionner uniquement une unité de calcul accolée à la matrice mémoire (dans le cas par exemple d'une mémoire de type NMC). Une opération de calcul peut également consister à réaliser une opération de lecture d'une ou plusieurs rangées avec actionnement de moyens de calcul placés en pied de colonne dans le cas par exemple d'une mémoire de type IMC). De façon générale, on peut considérer qu'une opération élémentaire peut être réalisée dans un cycle d'accès au circuit mémoire 201, comme cela est par exemple décrit dans la demande de brevet français N°20/08272 déposée le 4 août 2020 par le demandeur en relation avec les figures 4A, 4B.

Le module 200 de la figure 2 comprend en outre un circuit 207 (AD) de distribution des requêtes en provenance du processeur 231. Le circuit 207 est relié au processeur 231 par l'intermédiaire d'une liaison 233. Le circuit 207 est en outre relié au circuit de contrôle 205 du circuit mémoire 201 par une liaison 209 interne au module 200, et au circuit d'accès direct 203 par une liaison 211 interne au module 200. Le circuit 207 permet de contrôler la distribution du flux d'instructions en provenance du processeur 231 entre d'une part le circuit mémoire 201 (via la liaison 209 et le circuit de contrôle 205) et d'autre part le circuit d'accès direct 203 (via la liaison 211). Un mécanisme de type mappage mémoire peut être prévu pour réaliser le routage (aiguillage) des instructions vers l'un ou l'autre du circuit mémoire 201 et du circuit d'accès direct 203, en fonction d'un champ d'adresse contenu dans l'instruction.

Le processeur 231 peut requérir des accès en lecture ou en écriture au circuit mémoire 201, ou encore l'exécution de calculs par le circuit mémoire 201. Le processeur peut en outre requérir des transferts directs (via le circuit 203) de données entre le circuit mémoire 201 et un circuit périphérique externe au module 200, par exemple le circuit mémoire 253. Ces requêtes sont réparties entre le circuit de contrôle 205 et le circuit d'accès direct 203 par le circuit de distribution 207.

La figure 3 illustre plus en détail un exemple d'implémentation du système de la figure 2.

Le système de la figure 3 comprend les mêmes éléments que dans l'exemple de la figure 2, agencés sensiblement de la même manière.

Dans l'exemple de la figure 3, on a représenté plus en détail différents éléments du circuit d'accès direct 203 du module 200.

Plus particulièrement, dans cet exemple, le circuit 203 comprend un ensemble 301 (DMA IR) d'un ou plusieurs registres d'instructions. Les registres 301 reçoivent des instructions en provenance du processeur 231, par l'intermédiaire de la liaison 211. Les registres 301 stockent les instructions de transfert à exécuter par le circuit 203.

Les instructions stockées dans les registres 301 sont par exemple des instructions dédiées de contrôle du circuit d'accès direct 203, contenant notamment les plages d'adresses source et destination des transferts à réaliser, et des informations quant à la taille et, éventuellement, à l'agencement (motif ou "pattern" en anglais) des données à transférer dans le circuit mémoire source et dans le circuit mémoire destination (de manière à permettre de modifier l'arrangement des données lors de leur transfert entre la source et la destination).

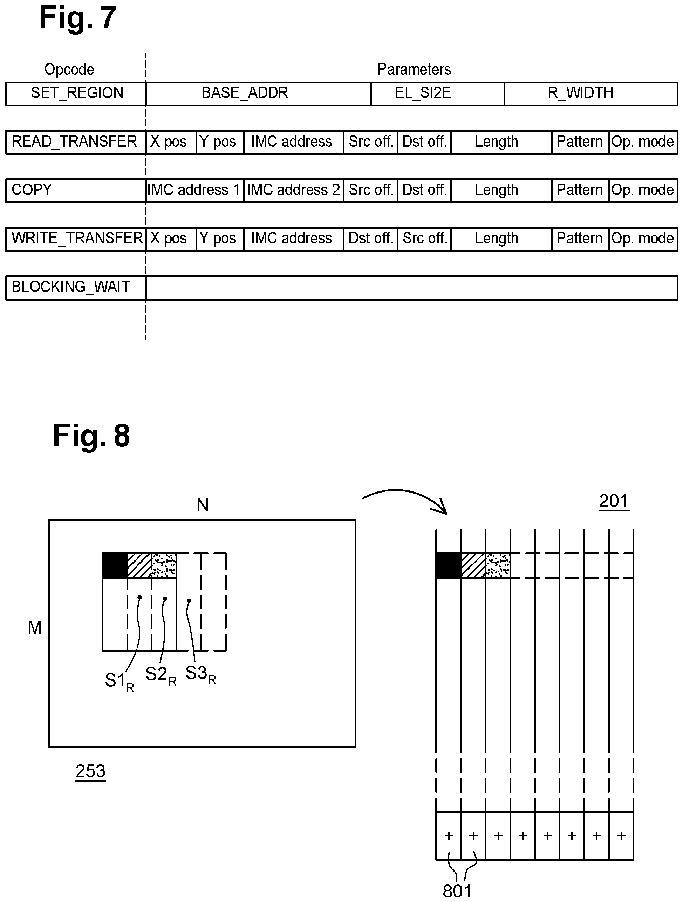

Un exemple de format d'instructions sera décrit plus en détail ci-après en relation avec la figure 7.

Un avantage du mode de réalisation décrit en relation avec la figure 7 est que l'ensemble des paramètres requis pour mettre en oeuvre un transfert de données peut être transmis au circuit 203 au moyen d'une instruction unique ou d'un nombre réduit d'instructions. Ceci permet de réduire le nombre de cycles d'occupation du processeur par rapport à un système dans lequel les différents paramètres du transfert sont écrits successivement dans des registres de configuration spécifiques du circuit d'accès direct. En effet, dans ce cas, un cycle d'écriture est nécessaire pour chaque paramètre du transfert. Dans la solution décrite en relation avec la figure 7, plusieurs paramètres sont transmis simultanément dans une même instruction, lors d'un même cycle. Les modes de réalisation décrits ne se limitent toutefois pas à ce cas particulier.

Le circuit 203 comprend en outre un circuit buffer 303 (BUF) relié au circuit mémoire 201 par l'intermédiaire de la liaison interne 204, et au bus système mémoire 251 par l'intermédiaire d'une liaison de transfert de données 321. Le circuit buffer 303 stocke temporairement les données transitant du circuit mémoire 201 vers le bus système mémoire 251, ou du bus système mémoire 251 vers le circuit mémoire 201.

Le circuit 203 comprend de plus un circuit logique de contrôle 305 (CL). Le circuit logique de contrôle 305 est relié d'une part aux registres d'instructions 301 et d'autre part au circuit buffer 303. Le circuit 305 est adapté à décoder les instructions stockées dans les registres 301. Le circuit 305 est adapté à commander des transferts de données éventuellement à l'intérieur du circuit buffer 303, et entre le circuit buffer 303 et les liaisons 204 et 321, en fonction de l'état de l'exécution d'une instruction préalablement stockée dans les registres 301. Lorsque l'exécution d'une instruction de transfert de données requise par le processeur 231 est terminée, le circuit logique de contrôle 305 renvoie une interruption au processeur 231 pour l'en informer. L'interruption peut être transmise par une liaison 323 (DMA interrupt) connectant le circuit 305 au processeur 231.

Le circuit 203 comprend en outre un circuit de génération d'adresses 307 (AG). Le circuit 307 est relié au circuit logique de contrôle 305. Le circuit 307 est en outre relié au bus système mémoire 251 par l'intermédiaire d'une liaison de transfert de signaux d'adresse 325. Le circuit de génération d'adresses 307 est adapté à générer une séquence de signaux d'adresse pour transférer successivement les données entre le circuit buffer 303 et le bus 251, conformément aux instructions stockées dans les registres 301.

Dans l'exemple représenté en figure 3, la liaison 241 reliant le circuit d'accès direct 203 au bus système mémoire 251 comprend un circuit d'interface de bus 241a (Bus Interface). Le circuit 241a est par exemple un circuit d'interface de bus maître. Le circuit 241a comprend un premier port relié, par exemple connecté, au bus 251, et un deuxième port relié, par exemple connecté, respectivement à un port d'entrée/sortie de données du circuit buffer 303 (via la liaison 321) et à un port d'entrée/sortie de signaux d'adresse du générateur d'adresses 307 (via la liaison 325).

Dans l'exemple de la figure 3, la liaison 255 reliant le bus système mémoire 251 au circuit mémoire externe 253 comprend un circuit d'interface de bus 255a (Mem Interface). Le circuit 255a est par exemple un circuit d'interface de bus esclave. Le circuit 255a comprend un premier port d'entrée/sortie relié, par exemple connecté, au bus 251, et un deuxième port d'entrée/sortie relié, par exemple connecté, à un port d'entrée/sortie du circuit mémoire 253.

Par ailleurs, dans l'exemple de la figure 3, la liaison 233 reliant le processeur 231 au circuit 207 de distribution des accès comprend un multiplexeur 233a (D-TCM interco) et un circuit d'interface 233b (D-TCM interface). Le circuit d'interface 233b est par exemple un circuit d'interface esclave. Le multiplexeur 233a comprend un premier port d'entrée/sortie relié, par exemple connecté, à un port d'entrée/sortie du processeur 231. Le multiplexeur 233a comprend en outre un deuxième port d'entrée/sortie relié directement (i.e. sans passer par le processeur 231) au bus système processeur 239 du système. Dans l'exemple représenté, un circuit d'interface de bus 233c (Interface), par exemple un circuit d'interface esclave, fait interface entre le bus système processeur 239 et le deuxième port d'entrée/sortie du multiplexeur 233a. Le circuit d'interface 233c comprend un premier port d'entrée/sortie relié, par exemple connecté, au bus 239, et un deuxième port d'entrée/sortie relié, par exemple connecté, au deuxième port d'entrée/sortie du multiplexeur 233a. Le multiplexeur 233a comprend en outre un troisième port d'entrée/sortie relié, par exemple connecté, à un premier port d'entrée/sortie du circuit d'interface 233b. Le circuit d'interface 233b a quant à lui un deuxième port d'entrée/sortie relié, par exemple connecté, à un port d'entrée/sortie du circuit 207. En fonctionnement, le multiplexeur est adapté à connecter alternativement l'un ou l'autre de ses premier et deuxième ports d'entrée/sortie à son troisième port d'entrée/sortie, de façon à relier le port d'entrée/sortie du circuit de répartition des accès 207 soit au processeur 231 soit directement au bus système processeur 239.

Dans l'exemple de la figure 3, le module 200 comprend en outre un circuit d'arbitrage 309 relié, par exemple connecté, d'une part au circuit de contrôle 205 du circuit mémoire 201, et d'autre part au circuit de contrôle 305 du circuit d'accès direct 203. Le circuit d'arbitrage 309 peut en outre être relié, par exemple connecté, aux registres d'instructions 301 du circuit d'accès direct 203. Le circuit 309 est adapté à gérer l'exécution des instructions réalisées in fine par le circuit mémoire 201 de manière à arbitrer entre des demandes d'accès potentiellement simultanées provenant du processeur 231 ou du circuit d'accès direct 203. Plus particulièrement, alors que le circuit 207 a pour fonction de distribuer les instructions reçues du processeur 231 respectivement au circuit de contrôle 205 du circuit mémoire 201 du module 200 et aux registres d'instructions 301 du circuit d'accès direct 203 du module 200, le circuit d'arbitrage 309 (Arb) gère les conflits éventuels entre des demandes de réalisation des opérations élémentaires dans le circuit mémoire 201 lors de l'exécution des instructions demandées par le processeur soit directement au circuit mémoire soit au circuit d'accès direct 203. Plus spécifiquement, chaque instruction est décomposée en une séquence d'opérations élémentaires par le circuit de contrôle 205 ou par le circuit de contrôle 305. Autrement dit, le circuit d'arbitrage 309 réalise un arbitrage entre deux flux parallèles distincts de requêtes d'opérations élémentaires, à savoir :

- un premier flux correspondant aux instructions envoyées par le processeur 231 au circuit mémoire 201, généré par le circuit de contrôle 205 ; et
- un deuxième flux correspondant à l'exécution des transferts de données entre le circuit mémoire 201 et le circuit mémoire externe 253, généré par le circuit de contrôle 305.

Les requêtes reçues par le circuit d'arbitrage 309 en provenance du circuit de contrôle 205 et du circuit de contrôle 305 sont autorisées ou retardées par le circuit d'arbitrage en fonction des conflits potentiels de demandes d'accès au circuit mémoire 201. Autrement dit, le circuit d'arbitrage 309 transmet au circuit de contrôle 205 du circuit mémoire 201 un unique flux de requête d'opérations élémentaires, appelé flux global, correspondant à une combinaison entrelacée des premier et deuxième flux, selon un ordonnancement défini par des règles de priorité prédéfinies. La granularité de l'entrelacement des premier et deuxième flux peut être à l'échelle des opérations élémentaires, ou à une échelle plus haut niveau, c'est-à-dire à une échelle de groupes d'opérations élémentaires.

Les instructions envoyées par le processeur 231 au circuit de contrôle 205 ou écrites dans les registres d'instruction 301 peuvent comporter des bits de priorité exploités in fine par le circuit d'arbitrage 309 pour décider de l'ordre de traitement des opérations élémentaires. Ainsi, selon un mode de réalisation, les premier et deuxième flux de requête d'opérations élémentaires reçus par le circuit d'arbitrage 309 peuvent chacun inclure un ou des bits de priorité indiquant la priorité correspondante de chaque opération élémentaire en fonction de la priorité indiquée par le processeur lors de l'envoi de l'instruction correspondante. Dans le cas par exemple où le circuit d'arbitrage 309 reçoit simultanément des requêtes d'opérations élémentaires pour chacun des premier et deuxième flux, alors une règle par défaut peut être donnée pour leur traitement. On peut par exemple donner toujours priorité au premier flux, ou donner priorité à tour de rôle entre les deux flux.

La liaison 204 reliant le circuit mémoire 201 au circuit d'accès direct 203, permettant de réaliser des transferts directs (sans passer par le processeur 231) de données entre le circuit mémoire 201 et le circuit mémoire distant 253 est par exemple adaptée à transmettre uniquement des signaux de données correspondant aux données lues ou à écrire dans le circuit mémoire 201 et correspondant respectivement à des données écrites ou lues dans le circuit buffer 303.

La largeur des données pouvant être transmises simultanément via la liaison 204 est par exemple égale ou supérieure à la largeur du bus système mémoire 251. Les modes de réalisation décrits ne se limitent toutefois pas à ce cas particulier.

Pour chaque requête d'opération élémentaire du deuxième flux, des signaux d'adresse et de contrôle utilisés pour indiquer l'adresse de chaque donnée à transférer, le type d'accès à réaliser (lecture ou écriture), la taille de la donnée à transférer, etc., peuvent être transmis par le circuit 305 au circuit de contrôle 205 du circuit mémoire 201, via le circuit d'arbitrage ou éventuellement directement. Quel que soit le mode de réalisation, il est nécessaire de prévoir un mécanisme de synchronisation entre le circuit d'arbitrage, le circuit de contrôle 205 et le circuit d'accès direct afin d'assurer que les signaux d'adresse et de contrôle correspondant à une requête d'opération élémentaire émise par le circuit logique 305 soient pris en compte par le circuit mémoire pour l'exécution de l'opération élémentaire en même temps que les données à écrire ou lire dans le circuit buffer 303 transitent sur la liaison 204 pour cette même opération élémentaire. Ainsi, par exemple, on peut prévoir qu'une requête d'opération élémentaire transmise au circuit d'arbitrage par le circuit logique 305 inclut toutes les informations d'adresse et de contrôle et que le circuit d'arbitrage envoie au circuit logique 305 une information, type requête d'acquittement, pour lui signifier qu'il lance l'exécution de l'opération élémentaire dans le circuit mémoire 201, et par suite que le circuit de transfert de données peut envoyer une donnée sur la liaison 204 (dans le cas d'une écriture dans le circuit mémoire 201) ou récupérer une donnée sur la liaison 204 (dans le cas d'une lecture dans le circuit mémoire 201). D'autres mécanismes de synchronisation entre le circuit d'arbitrage 309, le circuit mémoire 201 et le circuit d'accès direct 203 peuvent bien entendu être mis en place.

En outre, le circuit d'arbitrage a été représenté précédemment comme un circuit différent du circuit de contrôle 205 du circuit mémoire 201 afin principalement de mettre en avant la fonction d'arbitrage entre deux flux de requête d'opérations élémentaires souhaitant accéder à une même ressource, à savoir la matrice 103 et les moyens de calcul en mémoire (par exemple 107). Cette fonction d'arbitrage pourrait par exemple être réalisée par le circuit de contrôle 205 du circuit mémoire 201. Le circuit de contrôle 205 dialoguerait ainsi directement avec le circuit logique 305 et plus généralement le circuit d'accès direct 203. Le circuit de contrôle 205 recevrait ainsi, via deux ports d'entrée/sortie, des requêtes d'instructions du processeur 231 et des requêtes d'instructions du circuit 203 sous forme de requêtes d'opérations élémentaires, ou sous forme éventuellement d'instructions plus haut niveau à décoder par le circuit 205 en utilisant par exemple le même décodeur que celui utilisé pour décoder les instructions provenant du processeur 231. Selon un autre mode de réalisation, le circuit décodeur d'instructions présent dans le circuit de contrôle 205 est « déporté » dans le circuit d'arbitrage 309 et le circuit de contrôle 205 traite et reçoit un unique flux global de requête d'opérations envoyé par le circuit d'arbitrage 309.

La figure 4 représente plus en détail un exemple de réalisation du circuit d'accès direct de données 203 du module mémoire 200 de la figure 3.

Plus particulièrement, sur la figure 4, on a représenté plus en détail (en partie droite de la figure) un exemple de réalisation du circuit buffer 303 du circuit 203.

Dans cet exemple, le circuit buffer 303 comprend deux sous-circuits de transfert unidirectionnel 401 et 403 de type FIFO (de l'anglais "First In First Out" - premier entré premier sorti). Le circuit 401 est adapté à transmettre des données du circuit mémoire 201 du module 200 vers le bus système mémoire 251. Le circuit 403 est quant à lui adapté à transmettre des données du bus système mémoire 251 vers le circuit mémoire 201. Le circuit 401 comprend un port d'entrée relié à un port de sortie du circuit mémoire 201 (non visible sur la figure 4), via la liaison interne 204. Dans cet exemple, un registre de transmission de données 405 (TDR) fait interface entre la liaison 204 et le port d'entrée du circuit 401. Le circuit 401 comprend en outre un port de sortie relié au bus système mémoire 251, via la liaison 321. Dans cet exemple, un registre de transmission de données 407 (TSR) fait interface entre le port de sortie du circuit 401 et la liaison 321. Le circuit 403 comprend un port de sortie relié à un port d'entrée du circuit mémoire 201, via la liaison interne 204. Dans cet exemple, un registre de transmission de donnée 409 (RDR) fait interface entre le port de sortie du circuit 403 et la liaison 204. Le circuit 403 comprend en outre un port d'entrée relié au bus système mémoire 251,

via la liaison 321. Dans cet exemple, un registre de transmission de données 411 (RSR) fait interface entre la liaison 321 et le port d'entrée du circuit 403.

Les circuits 401 et 403 permettent de stocker temporairement les données pendant leur transfert du circuit mémoire 201 vers le bus système mémoire 251 ou du bus système mémoire 251 vers le circuit mémoire 201. Plus généralement, tout autre agencement du circuit buffer 303 adapté à remplir cette fonction peut être prévu.

Le circuit buffer 303 peut en outre avoir une fonction d'adaptation de la taille des données entre la liaison 204 et la liaison 321. A titre d'exemple, la liaison 204 peut avoir une largeur de données J, la liaison 321 peut avoir une largeur de données L, et le bus système mémoire 251 peut avoir une largeur de données I, avec J, L et I entiers supérieurs à 1. La largeur J peut être égale à la largeur L. A titre de variante, la largeur J peut être différente de la largeur L. Dans ce cas, le circuit buffer 303 est configuré pour adapter la taille des données transmises. Par exemple, la largeur J peut être supérieure à la largeur L. L'adaptation de la taille des données peut être réalisée par les registres 405, 407, 409 et 411. A titre d'exemple, les registres 409 et 411 peuvent être des registres à décalage. Par ailleurs, la largeur I peut être égale à la largeur L, ou différente de la largeur L. A titre d'exemple, la largeur I est inférieure à la largeur L. L'adaptation de taille des données (sérialisation) entre la liaison 321 et le bus système mémoire 251 peut être réalisée par le circuit d'interface 241a.

A titre d'exemple, non limitatif, la largeur J est égale à 2048 bits, la largeur L est égale à 512 bits, et la largeur I est égale à 128 bits.

La largeur des mots des buffers 401 et 403 est par exemple égale à la largeur J, ou à la largeur L.

A titre d'exemple, lors d'une transmission de données du bus système mémoire 251 vers le circuit mémoire 201, le buffer 403 est rempli successivement par sous-mots de largeur L jusqu'à ce qu'un mot complet de largeur J soit disponible pour être transmis au circuit mémoire 201 via la liaison 204. Lors d'une transmission de données du circuit mémoire 201 vers le bus système mémoire 251, le buffer 401 est lu par sous-mots de largeur L, transmis successivement au bus système mémoire 251 via la liaison 321.

Du point de vue de la programmation, le circuit d'accès direct 203 du module 200 est contrôlé par le processeur 231 par l'intermédiaire des registres d'instruction 301. Des instructions dédiées sont utilisées pour contrôler les transferts de données via le circuit 203.

Les accès en écriture au circuit mémoire 201 du module 200, par exemple pour transférer des données depuis le circuit mémoire externe 253 vers le circuit mémoire 201, via le circuit d'interface 241a et le circuit d'accès direct 203, peuvent être mis en oeuvre comme suit. D'abord, le processeur 231 écrit une instruction complète de transfert dans les registres d'instruction 301 du circuit 203 via le circuit d'interface 233b et le circuit 207 de distribution des instructions du module 200. L'instruction comprend notamment l'adresse source des données à transférer (c'est-à-dire l'adresse des données dans le circuit mémoire externe 253), la taille du bloc de données à transférer, l'adresse destination des données à transférer (c'est-à-dire l'adresse des données dans le circuit mémoire 201), et, éventuellement, une consigne de réagencement des données lors du transfert. Le circuit logique de contrôle 305 du circuit 203 décode l'instruction et génère une requête d'accès en lecture au circuit mémoire 253 à l'adresse source spécifiée (fournie par le générateur d'adresses 307). Cette requête est envoyée par le circuit d'interface 241a du module 200 au circuit d'interface 255a du circuit mémoire externe 253, via le bus système mémoire 251. Lorsque les données source sont prêtes, le circuit mémoire externe 253 envoie l'ensemble des données requises, par exemple en salve continue, directement dans le circuit buffer 303 du circuit 203, via les circuits d'interface 255a et 241a et le bus système mémoire 251. Les données sont ensuite transférées du circuit buffer 303 vers le circuit mémoire 201, par l'intermédiaire de la liaison interne 204 du module 200, lorsque le circuit d'arbitrage 309 autorise ce transfert. Ce transfert peut être un transfert continu au fur et à mesure que les données sont rendues disponibles en sortie du circuit buffer 303. A titre de variante, on peut attendre que la totalité des données soit disponible dans le circuit buffer 303 pour réaliser le transfert vers le circuit mémoire 201. Le choix du mode de transfert peut être effectué en fonction d'une éventuelle différence de fréquence de fonctionnement entre le circuit mémoire externe 253 et le circuit mémoire 201 du module 200. Lors du transfert, les adresses destination sont communiquées au circuit de contrôle 205 du circuit mémoire 201 par le circuit d'arbitrage 309. Lorsque l'exécution de l'instruction de transfert est terminée, une interruption est renvoyée par le circuit de contrôle 305 à destination du processeur.

Les accès en lecture au circuit mémoire 201 du module 200, par exemple pour transférer des données depuis le circuit mémoire 201 vers le circuit mémoire externe 253, via le circuit d'accès direct 203 du module 200 et le circuit d'interface 241a, peuvent être réalisés selon un chemin inverse à ce qui vient d'être décrit. Le processeur 231 écrit d'abord l'instruction complète dans les registres d'instruction 301 du circuit 203, via le circuit d'interface 233b et le circuit 207 de distribution des instructions du module 200. Le circuit logique de contrôle 305 du circuit 203 décode l'instruction et génère une requête d'accès en lecture au circuit mémoire 201 à l'adresse source spécifiée. Cette requête est transmise au circuit mémoire 201 par l'intermédiaire du circuit d'arbitrage 309 et du circuit de contrôle 205. Les données sont alors transférées du circuit mémoire 201 vers le circuit buffer 303 via la liaison 204. Le contenu du circuit buffer 303 est ensuite transféré à l'adresse destination du circuit mémoire externe 253, via la liaison 321, le circuit d'interface 241a, le bus système mémoire 251, et le circuit d'interface 255a.

Dans le système de la figure 3, des accès aux données du circuit mémoire 201 du module 200 peuvent aussi être réalisés directement par le processeur 231 ou le bus système processeur 239, via la liaison 233 et en particulier via le circuit d'interface 233b. Par exemple, des données peuvent être transférées du circuit mémoire externe 253 vers le circuit mémoire 201 du module 200 en passant, dans l'ordre, par : le bus système mémoire 251, un circuit d'interconnexion système 361 reliant le bus 251 au bus système processeur 239 du processeur, le bus système processeur 239, le circuit d'interface 233c, le circuit d'interface 233b, le circuit de distribution 207, et le circuit de contrôle 205. Pour transférer des données du circuit mémoire 201 vers le circuit mémoire externe 253, le chemin inverse peut être utilisé. De tels transferts peuvent toutefois être relativement longs et bloquer l'accès au processeur pendant une période de temps importante. Un avantage du circuit d'accès direct 203 est de permettre des transferts directs de données depuis ou vers le circuit mémoire 200, sans bloquer l'accès au processeur.

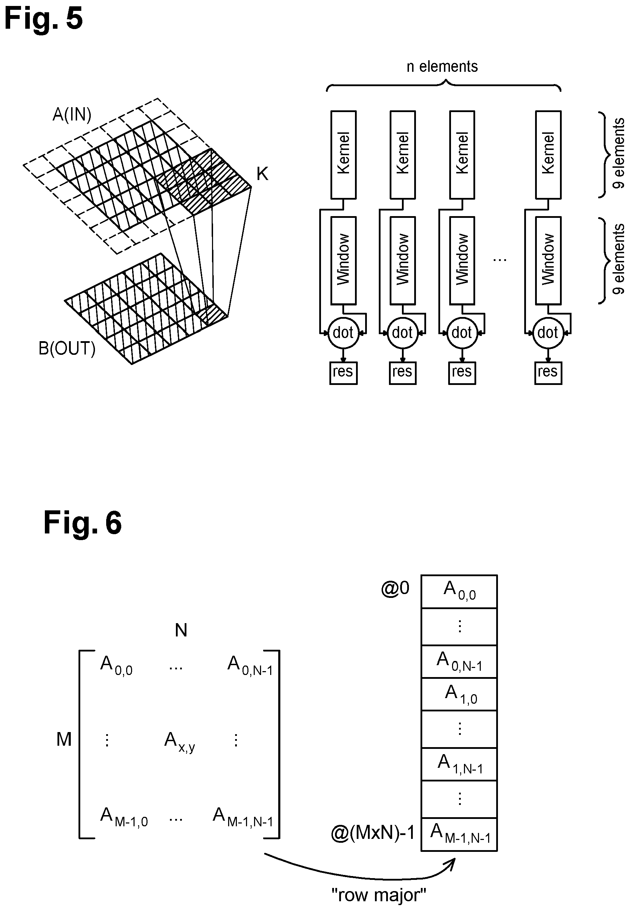

La figure 5 illustre schématiquement un exemple d'une opération de traitement de données pouvant être mise en oeuvre dans un système du type décrit en relation avec les figures 1 à 4.

Dans cet exemple, le traitement considéré est une opération de convolution d'une matrice d'entrée A(IN) par un noyau de convolution K, produisant une matrice de sortie B(OUT) .

Dans l'exemple représenté, la matrice d'entrée A(IN) est une matrice de 5x5 valeurs, le noyau de convolution est une matrice de 3x3 valeurs, et la matrice de sortie B(OUT) est une matrice de 5x5 valeurs. Les modes de réalisation décrits ne se limitent bien entendu pas à cet exemple particulier. En particulier, en pratique, les matrices A et B peuvent avoir des dimensions bien plus importantes. A titre d'exemple, la matrice A peut correspondre à une image de plusieurs milliers à plusieurs millions de valeurs.

La partie gauche de la figure 5 est une représentation matricielle des données d'entrée et de sortie et du noyau de convolution.

La partie droite de la figure représente les données stockées selon un agencement adapté à un traitement de l'opération de convolution par une unité de calcul vectoriel, sans réagencement des données.

Dans cet exemple, les valeurs du filtre de convolution sont stockées selon un vecteur colonne (Kernel) de 9 valeurs (9 éléments) répété à l'identique n fois (n éléments), où n désigne le nombre de produits de convolution nécessaire pour réaliser l'opération de convolution complète, soit n=25 dans l'exemple considéré.

Par ailleurs, pour chaque élément de la matrice d'entrée A(IN), les valeurs de la sous-matrice de 3x3 éléments centrée sur l'élément considéré sont stockées selon un vecteur colonne (Window) de 9 valeurs (9 éléments). Pour les éléments périphériques de la matrice d'entrée, des valeurs de remplissage par défaut peuvent être utilisées pour compléter les sous-matrices correspondantes.

Dans cet exemple, les n produits de convolution (somme des valeurs d'un vecteur de données d'entrée (Window) pondérées par les valeurs du noyau de convolution (Kernel)) sont réalisés en parallèle par respectivement n circuits de calcul (dot) de type multiplicateur accumulateur. Le résultat (res) de chaque produit de convolution définit une valeur de la matrice de sortie B(OUT).

Dans cet exemple, le calcul est réalisé ligne par ligne, par un circuit mémoire adapté à mettre en oeuvre des opérations de calcul. A titre d'exemple, on vient lire la première ligne des vecteurs colonne (Kernel) et la première ligne des vecteurs colonne (Window), on fait une multiplication point à point des deux vecteurs ligne de n éléments lus, et on stocke le résultat (i.e. un vecteur ligne de n éléments). On lit ensuite la deuxième ligne des vecteurs colonne (Kernel) et la deuxième ligne des vecteurs colonne (Window), on fait une multiplication point à point des deux vecteurs ligne de n éléments lus, on additionne le vecteur résultant au vecteur stocké à l'issue de l'étape précédente, et on stocke le résultat (i.e. un vecteur ligne de n éléments). Ces opérations sont réitérées pour chacune des lignes des vecteurs colonne (Kernel) et des vecteurs colonne (Window).

Plus généralement, les modes de réalisation décrits sont tout particulièrement avantageux pour mettre en oeuvre des calculs de type SIMD (de l'anglais "Single Instruction Multiple Data" - instruction simple données multiples), c'est-à-dire dans lesquels une même opération, ou séquences d'opérations, est répétée en parallèle à partir de différentes données.

Dans un système du type décrit en relation avec les figures 1 à 4, il peut être souhaitable de transférer les données du circuit mémoire externe 253 vers la mémoire 201, en vue de l'exécution des calculs de produits de convolution dans la mémoire 201. Lors du transfert, il est souhaitable que les données soient réagencées de façon à passer d'un agencement matriciel (tel que représenté en partie gauche de la figure 5) dans le circuit mémoire externe 253, à un agencement en colonnes (tel que représenté en partie droite de la figure 5) dans le circuit mémoire 201.

Pour cela, et afin de limiter l'occupation du processeur, le circuit d'accès direct 203 (DIMA) est de préférence adapté à réagencer les données selon une consigne prédéfinie lors de la mise en oeuvre d'un transfert du circuit mémoire 253 vers le circuit mémoire 201, ou inversement.

La consigne de réagencement peut alors être transmise au circuit d'accès direct 203 par le processeur 231, via le jeu d'instructions dédié utilisé par le processeur pour commander le circuit d'accès direct 203.

La figure 6 illustre plus en détail un exemple d'agencement des données dans le circuit mémoire externe 253.

Sur cette figure, on a représenté une matrice A de M lignes par N colonnes, correspondant, par exemple, à la matrice A de la figure 5, avec des dimensions M et N quelconques (M et N entiers supérieurs à 1). En partie gauche de la figure, on a représenté les valeurs $A_{x,y}$ de la matrice selon un agencement matriciel (avec x entier allant de 0 à M-1 désignant le rang de la ligne à laquelle appartient la valeur $A_{x,y}$, et y entier allant de 0 à N-1 désignant le rang de la colonne à laquelle appartient la valeur $A_{x,y}$).

En pratique, les données ne sont pas stockées selon cet agencement au sein du circuit mémoire 253, mais sont stockées selon un agencement prédéfini, par exemple de type "row-major" (ordre principal des lignes) ou "column major" (ordre principal des colonnes). A titre d'exemple, toutes les valeurs $A_{x,y}$ de la matrice A sont stockées à des adresses consécutives dans le circuit mémoire 253 à partir d'une adresse @0, selon un ordre de parcours prédéfini de la matrice A.

La partie droite de la figure 6 représente le stockage des M*N valeurs $A_{x,y}$ de la matrice dans le circuit mémoire 253, à partir d'un emplacement d'adresse @0. Dans cet exemple, les valeurs $A_{x,y}$ sont stockées selon un agencement de type "row major", c'est-à-dire en partant de la valeur $A_{0,0}$, en balayant chaque ligne de gauche (y=0) à droite (y=N-1) et en parcourant successivement les différentes lignes de haut (x=0) en bas (x=M-1). A chaque nouvelle valeur, l'adresse correspondante dans le circuit mémoire 253 est incrémentée d'un emplacement. Ceci permet que toutes les valeurs $A_{x,y}$ de la matrice soient stockées à des emplacements consécutifs dans le circuit mémoire 253. Ceci facilite l'accès aux données dans le circuit mémoire et permet notamment un gain en consommation électrique.

Si la taille de chaque valeur $A_{x,y}$ est différente de la taille d'un mot de données dans le circuit mémoire 253, l'incrémentation des adresses peut être adaptée en conséquence. Par exemple, si la taille des valeurs $A_{x,y}$ est égale au double de la taille d'un mot de données dans le circuit mémoire 253, l'adresse sera incrémentée de deux emplacements à chaque nouvelle valeur $A_{x,y}$. Dans un autre exemple, si la taille des valeurs $A_{x,y}$ est égale à la moitié de la taille d'un mot de donnée dans le circuit mémoire 253, on peut stocker deux valeurs $A_{x,y}$ consécutives à chaque emplacement mémoire. Ainsi, l'adresse sera incrémentée d'un emplacement toutes les deux valeurs $A_{x,y}$.

Connaissant l'adresse @0 de la première valeur $A_{0,0}$ de la matrice, l'adresse Addr $(A_{x,y})$ de chaque valeur $A_{x,y}$ de la matrice peut être déterminée par la formule suivante :

$$\text{Addr}(A_{x,y}) = @0 + EL\_SIZE*(x*N+y),$$

où EL_SIZE désigne la taille des valeurs $A_{x,y}$ en nombre de mots de données du circuit mémoire 253 (par exemple EL_SIZE=2 si les valeurs $A_{x,y}$ font le double de la taille d'un mot de données dans le circuit mémoire 253, ou EL_SIZE=1/2 si les valeurs $A_{x,y}$ font la moitié de la taille d'un mot de données dans le circuit mémoire 253).

De façon similaire, à l'issue d'une opération de traitement, les données de la matrice résultante (la matrice B dans l'exemple de la figure 5) peuvent être réécrites selon un agencement du même type dans le circuit mémoire 253.

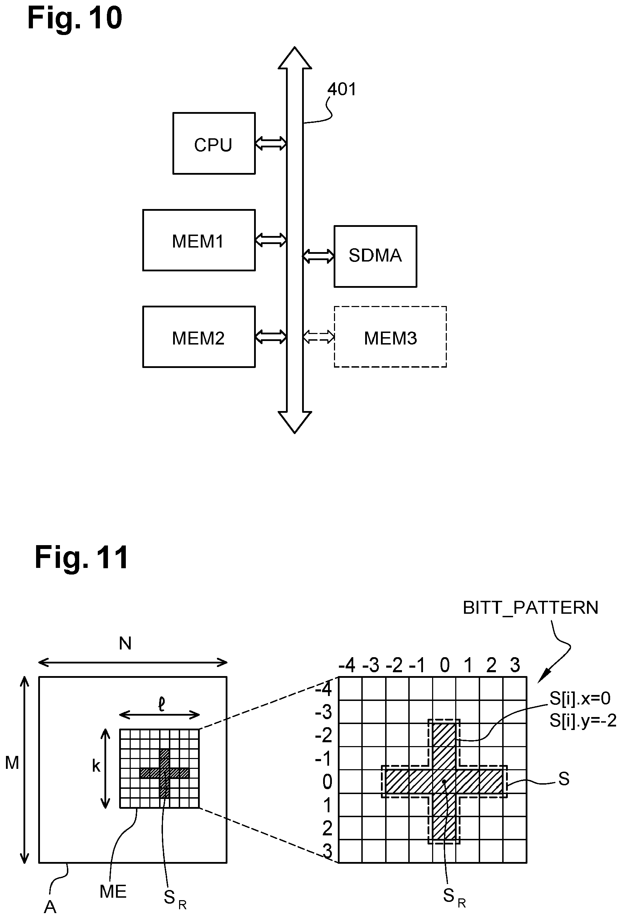

La figure 7 illustre schématiquement un exemple d'un jeu d'instructions utilisé par le processeur pour commander le circuit d'accès direct 203 dans le système de la figure 2, ou dans un système plus générique tel que décrit infra (figure 10 notamment). Ces instructions peuvent être envoyées au circuit d'accès direct 203 par le processeur par l'intermédiaire du circuit de distribution 207, ou d'un circuit équivalent.

Dans cet exemple, on a défini un jeu de cinq instructions. Chaque instruction comprend un premier champ (Opcode) contenant un code d'opération, définissant le type d'instruction à exécuter, et un deuxième champ (Parameters) contenant des paramètres de l'instruction.

Le jeu d'instructions de la figure 7 comprend une instruction SET_REGION de définition d'une sous-région du circuit mémoire externe 253, contenant les données à transférer ou destinées à recevoir des données selon le sens du transfert. La sous-région est une zone de la mémoire 253 contenant (ou destinée à contenir) une matrice de valeurs ordonnées, par exemple, selon un agencement de type "row major" tel que décrit en relation avec la figure 6. Dans cet exemple, la sous-région est définie par une adresse de base, correspondant, par exemple, à l'emplacement du premier élément de la matrice (adresse @0 de la valeur $A_{0,0}$ dans l'exemple de la figure 6), par la taille des éléments de la matrice, et par le nombre de d'éléments par ligne dans la matrice (nombre N de colonnes dans l'exemple de la figure 6).

Le champ de paramètres de l'instruction SET_REGION comprend un premier sous champ (BASE_ADDR) contenant l'adresse du premier élément de la sous-région (par exemple l'adresse @0 dans l'exemple de la figure 6), un deuxième sous-champ (EL_SIZE)) contenant la taille des éléments de la matrice définissant la sous-région (par exemple 1 si la taille des éléments de la matrice est égale à la taille d'un mot dans la mémoire 253), et un troisième sous-champ (R_WIDTH) contenant une valeur définissant la largeur de la matrice (par exemple le nombre N de colonnes de la matrice dans l'exemple de la figure 6).

Comme expliqué ci-dessus en relation avec la figure 6, à partir de ces paramètres, l'adresse de n'importe quel élément de position x,y dans la sous-région matricielle définie par l'instruction SET_REGION peut être déterminée par la formule Addr(x,y) = BASE_ADDR + EL_SIZE*(x*N+y). Ainsi, une fois la sous-région définie au moyen de l'instruction SET_REGION, il suffit, pour accéder à un élément quelconque de la sous-région, de transmettre au circuit d'accès direct 203 uniquement les coordonnées x,y de l'élément dans la matrice A, et non l'adresse complète de l'élément dans la mémoire 253.

Le jeu d'instructions de la figure 7 comprend en outre une instruction READ_TRANSFER de commande d'un transfert asynchrone de séquences de données de la sous-région de la mémoire externe 253 (aussi appelée mémoire source), définie au préalable au moyen de l'instruction SET_REGION, vers la mémoire destination, ici la mémoire CSRAM 201. L'instruction READ_TRANSFER prend pour paramètres un motif (agencement) élémentaire de données à transférer de la mémoire source vers la mémoire destination. Plusieurs itérations du motif peuvent être transférées de la mémoire source vers la mémoire destination, avec un décalage prédéfini en lecture et un décalage prédéfini en écriture entre deux itérations consécutives de transfert du motif. Autrement dit, la séquence de données peut comprendre plusieurs itérations (ou répétitions) de transfert d'un même motif élémentaire, situées à des emplacements distincts, régulièrement espacés, dans la sous-région de la mémoire source définie au préalable au moyen de l'instruction SET_REGION.

Le champ de paramètres de l'instruction READ_TRANSFER comprend un premier sous champ (X pos) et un deuxième sous-champ (Y pos) contenant les coordonnées, dans la sous-région préalablement définie dans le circuit mémoire source par l'instruction SET_REGION, d'une première cellule de référence de la séquence de données à transférer. L'adresse définie par les sous champ (X pos) et (Y pos) est une adresse relative dans la sous-région définie au préalable au moyen de l'instruction SET_REGION (coordonnées x et y dans la représentation matricielle de la sous-région). Ainsi, le poids (nombre de bits) utilisé pour transmettre cette adresse est inférieur au nombre de bits nécessaires pour coder l'adresse complète de la cellule dans la mémoire source.

Le champ de paramètres de l'instruction READ_TRANSFER comprend en outre un troisième sous-champ (IMC address) définissant l'adresse d'écriture de départ de la séquence dans le circuit mémoire destination. On notera que l'adresse définie dans ce troisième sous-champ peut être une adresse relative, la plage d'adressage du circuit mémoire destination étant connue du circuit d'accès direct. Par exemple, le circuit d'accès direct est associé au circuit mémoire destination soit de par son positionnement matériel proche de ce circuit mémoire soit de par une configuration du circuit d'accès direct au moyen par exemple d'un registre de configuration du circuit d'accès direct qui est accessible au processeur externe, le circuit d'accès direct connaissant, du fait de cette association, la plage d'adresses système permettant d'accéder au circuit mémoire intelligent via un bus système comprenant un bus d'adresses. Le champ IMC address contient les coordonnées relatives, dans cette plage d'adresse système dédiée au circuit mémoire destination, d'une cellule de référence servant de point de départ pour l'écriture des données dans le circuit mémoire destination. Ceci permet de limiter le nombre de bits à transmettre pour définir l'adresse destination de la séquence de données à transférer.

Le champ de paramètres de l'instruction READ_TRANSFER comprend en outre un quatrième sous-champ (Src off.) définissant le décalage, en lecture, dans la mémoire source, entre deux itérations consécutives du motif élémentaire à transférer.

Le champ de paramètres de l'instruction READ_TRANSFER comprend en outre un cinquième sous-champ (Dst off.) définissant le décalage, en écriture, dans la mémoire destination, entre deux itérations consécutives du motif élémentaire à transférer.

Le champ de paramètres de l'instruction READ_TRANSFER comprend en outre un sixième sous-champ (Length) définissant le nombre d'itérations du motif élémentaire à transférer de la mémoire source vers la mémoire destination.

Dans cet exemple, le champ de paramètres de l'instruction READ_TRANSFER comprend en outre un septième sous-champ (Pattern) définissant la forme du motif élémentaire à transférer, c'est-à-dire l'agencement spatial des données du motif dans la mémoire source autour d'un point de référence. Le motif élémentaire est balayé et transféré selon un ordre de lecture prédéfini. Les données du motif élémentaire sont réagencées, par exemple selon une ou plusieurs lignes ou selon une ou plusieurs colonnes, lors de leur écriture dans le circuit mémoire destination. Le choix de l'agencement dans le circuit mémoire destination dépend de l'organisation des données dans le circuit mémoire destination pour permettre la mise en oeuvre de calculs.

Le champ de paramètres de l'instruction READ_TRANSFER peut en outre comprendre un huitième sous-champ (Op. mode) définissant si les écritures effectuées conservent partiellement ou non les données initialement stockée dans la région d'écriture de la mémoire destination lorsque le quatrième sous-champ (Dst off.) est différent de 1, autrement dit supérieur ou égal à 2. Dans un premier mode de fonctionnement aussi appelé "zéro padding", les données enjambées, lors de l'écriture, par l'application du décalage défini dans le quatrième sous-champ (Dst off.), sont remplacées par des zéro. Dans un deuxième mode de fonctionnement, aussi appelé "overwriting mode", les données enjambées, lors de l'écriture, par l'application du décalage défini dans la quatrième sous-champ (Dst off.) sont conservées en l'état.

Le jeu d'instructions de la figure 7 comprend en outre une instruction WRITE_TRANSFER de commande d'un transfert asynchrone de séquences de données dans le sens inverse de ce qui vient d'être décrit. Ainsi, dans cet exemple, la mémoire source est la mémoire CSRAM 201 et la mémoire destination est la mémoire externe 253. De façon similaire à ce qui vient d'être décrit, l'instruction WRITE_TRANSFER prend pour paramètres un motif (agencement) élémentaire de données à transférer de la mémoire source vers la mémoire destination. Plusieurs itérations du motif peuvent être transférées de la mémoire source vers la mémoire destination, avec un décalage prédéfini en lecture et un décalage prédéfini en écriture entre deux itérations consécutives du motif.

Le champ de paramètres de l'instruction WRITE_TRANSFER comprend un premier sous champ (X pos) et un deuxième sous-champ (Y pos) définissant l'adresse d'écriture de départ de la séquence dans la mémoire destination. Là encore, l'adresse définie par les sous champ (X pos) et (Y pos) est une adresse relative dans la sous-région de la mémoire destination définie au préalable au moyen de l'instruction SET_REGION (coordonnées x et y de l'élément dans la zone matricielle définie par l'instruction SET_REGION). Ainsi, le poids (nombre de bits) utilisé pour transmettre cette adresse est inférieur au nombre de bits de l'adresse complète de la cellule dans la mémoire source.

Le champ de paramètres de l'instruction WRITE_TRANSFER comprend un troisième sous champ (IMC address) définissant l'adresse de lecture de départ de la séquence dans le circuit mémoire source. Comme décrit précédemment, cette adresse est une adresse relative, la sous-plage d'adresses du circuit mémoire source étant connue du circuit d'accès direct.

Le champ de paramètres de l'instruction WRITE_TRANSFER comprend en outre un quatrième sous-champ (Dst off.) définissant le décalage, en écriture, dans la mémoire destination, entre deux itérations consécutives du motif élémentaire à transférer.

Le champ de paramètres de l'instruction WRITE_TRANSFER comprend en outre un cinquième sous-champ (Src off.) définissant le décalage, en lecture, dans la mémoire source, entre deux itérations consécutives du motif élémentaire à transférer.

Le champ de paramètres de l'instruction WRITE_TRANSFER comprend en outre un sixième sous-champ (Length) définissant le nombre d'itérations du motif élémentaire à transférer de la mémoire source vers la mémoire destination.

Le champ de paramètres de l'instruction WRITE_TRANSFER comprend en outre un septième sous-champ (Pattern) définissant la forme du motif élémentaire à transférer, c'est-à-dire l'agencement spatial des données du motif dans le circuit mémoire source.

Le champ de paramètres de l'instruction WRITE_TRANSFER peut en outre comprendre un huitième sous-champ (Op. mode) définissant si les écritures effectuées conservent partiellement ou non les données initialement stockées dans la région d'écriture de la mémoire destination, lorsque le quatrième sous-champ (Dst off.) est différent de 1, autrement dit supérieur ou égal à 2 (modes de fonctionnement de type "zéro padding" ou "overwriting" tels que définis ci-avant).

Le jeu d'instructions de la figure 7 peut en outre comprendre une instruction BLOCKING_WAIT pour bloquer l'exécution de l'hôte jusqu'à ce qu'un transfert en cours soit terminé.

Le jeu d'instructions de la figure 7 peut de plus comprendre une instruction COPY de commande d'un transfert interne de données d'un premier emplacement vers un deuxième emplacement dans la mémoire CSRAM 201, qui est alors à la fois la mémoire source et la mémoire destination. Là encore, l'instruction COPY prend pour paramètres un motif (agencement) élémentaire de données à transférer. Plusieurs itérations du motif peuvent être transférées de la mémoire source vers la mémoire destination, avec un décalage prédéfini en lecture et un décalage prédéfini en écriture entre deux itérations consécutives du motif.

Le champ de paramètres de l'instruction COPY comprend un premier sous champ (IMC address 1) définissant l'adresse de lecture de départ de la séquence dans la mémoire 201.

Le champ de paramètres de l'instruction COPY comprend en outre un deuxième sous champ (IMC address 2) définissant l'adresse d'écriture de départ de la séquence dans la mémoire 201.

Le champ de paramètres de l'instruction COPY comprend en outre un troisième sous-champ (Src off.) définissant le décalage, en lecture, dans la mémoire, entre deux itérations consécutives du motif élémentaire à transférer.

Le champ de paramètres de l'instruction COPY comprend en outre un quatrième sous-champ (Dst off.) définissant le décalage, en écriture, dans la mémoire, entre deux itérations consécutives du motif élémentaire à transférer.

Le champ de paramètres de l'instruction COPY comprend en outre un cinquième sous-champ (Length) définissant le nombre d'itérations du motif élémentaire à transférer à l'intérieur de la mémoire 201.

Le champ de paramètres de l'instruction COPY comprend en outre un sixième sous-champ (Pattern) définissant la forme (agencement spatial des données dans la mémoire) du motif élémentaire à transférer. On notera que les données du motif élémentaire peuvent être réagencées, par exemple selon une ou plusieurs lignes ou selon une ou plusieurs colonnes ou selon tout autre agencement souhaité, lors de leur réécriture dans la mémoire (en fonction de l'agencement nécessaire pour réaliser des calculs, par exemple de type SIMD).

Le champ de paramètres de l'instruction COPY peut en outre comprendre un septième sous-champ (Op. mode) définissant si les écritures effectuées conservent partiellement ou non les données initialement stockée dans la région d'écriture de la mémoire destination, lorsque le quatrième sous-champ (Dst off.) est différent de 1, autrement dit supérieur ou égal à 2.

Dans cet exemple, l'instruction SET_REGION permet de définir une région d'intérêt dans la mémoire externe 253, généralement de grandes dimensions, avant d'exécuter les instructions de transfert READ_TRANSFER et/ou WRITE_TRANSFER. A titre d'exemple, la région d'intérêt correspond à une image ou une matrice d'entrée (A dans l'exemple de la figure 5) ou une matrice de sortie (B dans l'exemple de la figure 5) stockée selon un agencement prédéfini, par exemple de type "row major", dans la mémoire 253. Suite à une opération de transfert READ (pour transférer les éléments de la matrice A dans la mémoire de calcul 201), on souhaite appliquer un traitement, par exemple de convolution, grâce aux moyens de calcul de la mémoire CSRAM 201, de façon à générer les éléments d'une matrice résultat ou matrice de sortie (B dans l'exemple de la figure 5). En pratique, les calculs dans la mémoire CSRAM 201 sont initiées par une instruction envoyée par le CPU 231 à la CSRAM. Cette ou ces instructions de calculs prévoient avantageusement que les éléments de cette matrice B résultat soient stockés dans la mémoire CSR_AM 201 à l'issue des opérations de calcul. Plus particulièrement, le CPU demande à la CSRAM, via ses instructions de calcul, d'écrire les éléments de la matrice B dans la mémoire CSRAM 201 en les rangeant par exemple selon la configuration de rangement « row major », pour obtenir un rangement de la matrice B similaire à celui représenté pour la matrice A en figure 6, les éléments de la matrice B étant placés à des adresses consécutives de la mémoire 201. Une fois les éléments de la matrice B rangés dans la mémoire CSRAM 201, il est possible alors de réaliser un transfert de ces éléments vers la mémoire externe 253, grâce à la mise en oeuvre de l'instruction WRITE_TRANSFER. L'opération de WRITE_TRANSFER vers la mémoire externe 253 peut consister en un simple transfert du « bloc de données » constitutif de la matrice B stockées dans des adresses consécutives (nombre d'adresses : M*N éléments * EL_SIZE) vers un autre « bloc de données de destination » stockées dans des adresses consécutives dans la mémoire externe 253. Pour réaliser ce « simple transfert », il est possible de lancer une opération WRITE_TRANSFER avec un motif simple comprenant un unique élément. On peut également définir par convention qu'un champ Pattern égal à « 0 » correspond à un simple transfert sans réagencement des données.

Alternativement, il est possible qu'à la suite du calcul de la matrice B, rangées dans la CSRAM, on souhaite en pratique réaliser un calcul sur cette matrice B pour générer une matrice C. On pourra alors utiliser l'instruction COPY pour lancer un transfert de données consistant à réarranger les éléments de la matrice B dans la mémoire CSRAM 201 pour les organiser par exemple en colonnes ou en lignes selon l'agencement des opérateurs de calcul (en pied de colonnes ou de lignes). Une fois l'instruction COPY réalisée, le CPU peut lancer une instruction de calcul dans la CSRAM pour obtenir les données constitutives de la matrice C. Comme précédemment décrit pour les données de la matrice B, les données de la matrice C peuvent alors, sur requête du CPU à la CSRAM, être rangées dans des adresses consécutives, avec un rangement « row major ». Les éléments de cette matrice C pourront ensuite être éventuellement transférées vers la matrice externe 253 si on ne souhaite plus réaliser de calcul sur ces éléments dans la mémoire CSRAM 201.

On notera que les motifs « complexes » sont définis à partir de plusieurs éléments à récupérer dans la mémoire source autour d'un élément central, contrairement à ce motif « simple » comprenant uniquement un élément à récupérer dans la mémoire source. L'élément à récupérer est une donnée présentant un nombre de bits défini par le paramètre EL_SIZE. On notera que ce paramètre EL_SIZE est défini dans l'instruction SET_REGION. Ainsi, si EL_SIZE est défini de manière relative, il faut considérer la taille d'un mot de données de la mémoire concernée par l'instruction SET_REGION pour connaître le nombre de bits de EL_SIZE. Alternativement, le paramètre EL_SIZE peut être défini de façon absolue par un nombre de bits directement.

Le jeu d'instructions précédemment décrit comprenant une instruction du type SET_REGION et au moins une instruction de transfert (READ, WRITE) permet de compresser le poids total des paramètres d'instructions devant être envoyées au circuit d'accès direct 203 pour exécuter les transferts de la mémoire 253 vers la mémoire 201 et/ou de la mémoire 201 vers la mémoire 253. Une fois la région d'intérêt définie au moyen de l'instruction SET_REGION, des positions relatives dans la région d'intérêt peuvent être utilisées comme paramètres dans les instructions READ_TRANSFER et WRITE_TRANSFER. Ceci permet de réduire le nombre de bits requis, dans les instructions envoyées par le processeur au circuit d'accès direct, pour définir les adresses des données à transférer dans la mémoire 201, en particulier lorsque plusieurs instructions READ_TRANSFER et/ou WRITE_TRANSFER successives sont exécutées dans une même sous-région entre deux exécutions successives de l'instruction SET_REGION.

On notera que le champ de paramètres de l'instruction SET_REGION peut comprendre un ou plusieurs bits additionnels permettant de définir plusieurs sous-régions d'intérêt, par exemple une sous-région de lecture, pour les transferts de la mémoire 253 vers la mémoire 201, et une sous-région d'écriture, distincte de la sous-région de lecture, pour les transferts de la mémoire 201 vers la mémoire 253. Ainsi, le circuit d'accès direct 203 peut comprendre en pratique plusieurs registres mémorisant les paramètres de l'instruction SET_REGION pour une ou plusieurs opérations de type READ ou une ou plusieurs opérations de type WRITE. De manière similaire, les instructions READ et WRITE peuvent comprendre un ou plusieurs bits additionnels permettant de définir des opérations READ type 1 ou type 2 (ou n), et des opérations WRITE type 1, type 2 (ou n). On peut ainsi par exemple prévoir de stocker plusieurs informations de BASE_ADDR pour chaque opération READ et/ou WRITE susceptible d'être requises par le processeur après une ou des instructions initiales SET_REGION permettant de définir les zones de données dans la mémoire externe, ou une autre mémoire, qui devront être considérées lors de l'exécution des opérations de READ ou de WRITE subséquentes.

L'utilisation d'instructions dédiées du type décrit en relation avec la figure 7, décodées par un circuit de contrôle interne au circuit d'accès direct 203, permet avantageusement de réduire le temps et le nombre de cycles processeur nécessaires pour transmettre des instructions de transfert au circuit d'accès direct 203. Cette réduction résulte notamment de la compression des adresses rendue possible par la définition, via l'instruction SET_REGION, d'une sous-région d'intérêt (contenant ou destinée à contenir les données d'une matrice) dans le circuit mémoire source ou destination, mais aussi par le fait que l'adressage du circuit mémoire CSRAM 201 est réalisé de façon relative, dans une sous-plage d'adresses connue du circuit d'accès direct.

La figure 8 illustre schématiquement l'exécution d'une opération de transfert de données dans le système de la figure 2, par exemple définie par une instruction READ_TRANSFER du jeu d'instructions de la figure 7.

On a représenté en partie gauche de la figure une sous-région d'intérêt définie au préalable dans la mémoire source 253 au moyen de l'instruction SET_REGION.Sur la figure 8, la sous-région est représentée sous forme matricielle (matrice de M lignes par N colonnes), étant entendu que, en pratique, le stockage des valeurs de la matrice dans la mémoire 253 peut être réalisé selon un agencement différent, par exemple un agencement de cellules d'adresses consécutives dans la mémoire, par exemple un agencement de type "row major".

Dans cet exemple, on souhaite transférer trois itérations d'un motif élémentaire en forme de matrice de 3*3 éléments (dans la représentation matricielle de la vue gauche de la figure 8), par exemple dans le but de réaliser trois opérations de multiplication matricielle par un même noyau de convolution. Le noyau de convolution constitue ici le motif (complexe) que l'on souhaite utiliser pour le transfert.

Comme expliqué précédemment en relation avec la figure 5, on cherche ici à transférer chaque itération du motif élémentaire en réagençant les données du motif selon un vecteur colonne couplé à un opérateur élémentaire de multiplication-accumulation 801 (en partie droite de la figure). Dans l'exemple représenté, le circuit mémoire 201 dispose de huit opérateurs de multiplication-accumulation. Seuls trois opérateurs sont utilisés dans cet exemple (les trois premiers en partant de la gauche), car on souhaite transférer et calculer uniquement 3 convolutions. On réalise donc 3 itérations de transfert selon le motif correspondant au noyau de convolution. Pour rappel, le nombre d'itérations du motif que l'on souhaite transférer est défini par le paramètre Length.

Chaque itération du motif élémentaire dans la sous-région de travail de la mémoire 253 est définie à partir d'une cellule de référence associée à cette itération, par exemple la cellule centrale du motif élémentaire dans sa représentation matricielle. Sur la figure 8, on a désigné respectivement par $S1_R$, $S2_R$ et $S3_R$ les cellules de référence des trois itérations successives du motif que l'on souhaite transférer. L'adresse X pos, Y pos transmise au circuit d'accès direct 203 via l'instruction READ_TRANSFER correspond par exemple à l'adresse de la cellule de référence $S1_R$ de la première itération du motif élémentaire à transférer (adresse relative dans la sous-région de travail définie par l'instruction SET_REGION). Dans cet exemple, le paramètre Length de l'instruction READ_TRANSFER est égal à 3 (la séquence de données à transférer comprend trois itérations du motif élémentaire). Le champ IMC address définit par exemple l'adresse d'écriture, dans la mémoire destination 201, de la première cellule de la première itération du motif élémentaire. Le paramètre Src off. définit le pas, en nombre d'éléments (de taille EL_SIZE), entre deux itérations successives du motif élémentaire dans la mémoire source 253, c'est-à-dire le décalage d'adresse, dans la mémoire source 253, entre la cellule $S1_R$ et la cellule $S2_R$, et entre la cellule $S2_R$ et la cellule $S3_R$ (Src off.=1 dans l'exemple représenté). Le paramètre Dst off. définit le pas, en nombre d'éléments, entre deux itérations successives du motif élémentaire dans la mémoire destination 201 (Dst off.=1 dans l'exemple représenté) sur une même ligne de données dans la mémoire CSRAM (si les opérateurs de calcul sont alignés avec les colonnes). Le motif élémentaire de la séquence (matrice de 3*3 éléments dans cet exemple) est quant à lui défini par le paramètre Pattern de l'instruction READ_TRANSFER.

Sur la figure 8, on a représenté respectivement en noir, en traits hachurés, et en pointillés, la première cellule de chacune des trois itérations du motif (la première cellule du motif correspondant à celle (« en haut à gauche » dans cet exemple). Pour chaque itération du motif, les cellules suivantes du motif sont écrites dans la même colonne que la première cellule du motif, en vis-à-vis respectivement de trois des huit opérateurs de calcul 801.

On notera que les écritures dans la première ligne (correspondant à la première cellule de chaque itération du motif) de la mémoire CSRAM se font par un incrément d'adresse simple (unitaire si EL_SIZE correspond à la taille d'un mot de la CSRAM 201) entre chaque écriture. Il en est de même pour les écritures dans la deuxième ligne (correspondant à la deuxième cellule de chaque itération du motif). Néanmoins, entre l'écriture de la 3ème donnée de la première ligne et l'écriture de la 1ère donnée de la deuxième ligne, il est nécessaire de réaliser un « saut d'adresse » correspondant dans cet exemple à un saut de 5 adresses. La longueur de ce saut d'adresses peut être défini dans un paramètre SEQ_OFF pouvant être prédéfini connaissant l'organisation de la mémoire CSRAM (l'organisation de son mappage d'adresse en mémoire) et connaissant le nombre de colonnes associées à un opérateur de calcul que l'on souhaite utiliser, et défini ici à partir du paramètre Length.

On notera que dans le cas où le paramètre Length est plus grand que le nombre d'opérateurs disponibles dans la mémoire CSRAM, il est possible d'utiliser plusieurs lignes a, b, c..., de préférence successives (notamment en terme d'adressage), pour ranger tous les premiers éléments de chacune des itérations du motif, et idem pour tous les deuxièmes éléments des itérations du motif, et ainsi de suite. Les opérateurs de calcul seront alors utilisés successivement pour réaliser le calcul souhaité à partir des lignes « a », puis ensuite des lignes « b », puis des lignes « c » et ainsi de suite.

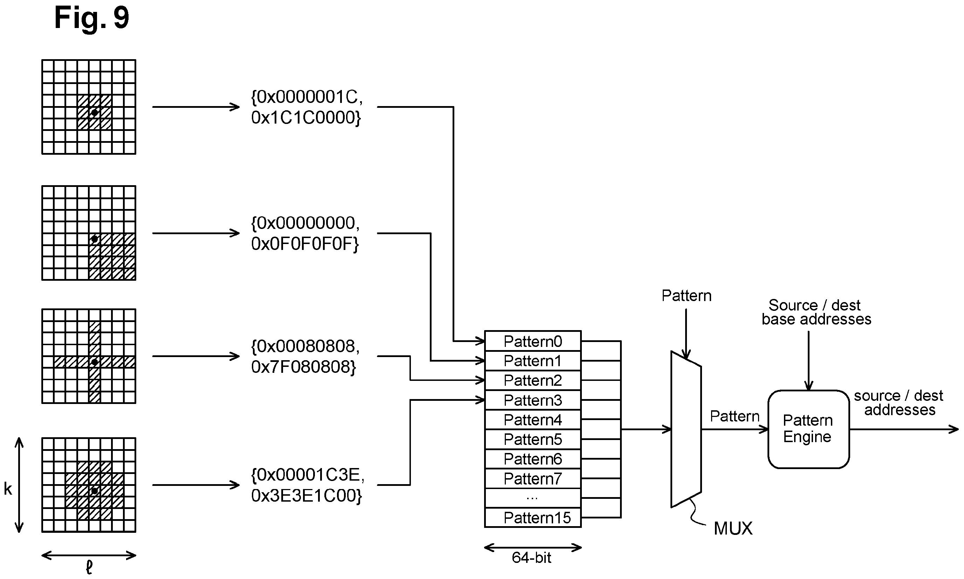

La figure 9 représente de façon schématique et partielle un exemple d'implémentation d'un circuit de contrôle du circuit d'accès direct de données 203 du système de la figure 2.

La figure 9 illustre plus particulièrement un exemple de mécanisme de génération des adresses dans la mémoire source et et la mémoire destination par le circuit d'accès direct 203 du système de la figure 2.

Ce mécanisme est par exemple mis en oeuvre par le circuit de contrôle 305 et/ou le circuit de génération d'adresses 307 dans l'exemple d'implémentation de la figure 3.

Dans l'exemple de la figure 9, plusieurs motifs élémentaires prédéfinis sont stockés sous la forme de suites de bits dans une mémoire interne du circuit d'accès direct 203, par exemple une mémoire RAM (de l'anglais "Random Access Memory" - mémoire à accès aléatoire) ou une mémoire ROM ("Read Only Memory" - mémoire à accès en lecture seule).

Les motifs élémentaires sont tous définis dans une même matrice élémentaire prédéfinie de dimensions k*l (avec k et l entiers, et avec, de préférence, k et/ou l supérieur ou égal à 2). Les dimensions k et l sont par exemple inférieures respectivement aux dimensions M et N de la sous-région matricielle définie au moyen de l'instruction SET_REGION. Dans l'exemple représenté, les motifs élémentaires sont tous définis dans une même matrice élémentaire de 8*8 cellules mémoire voisines (k=l=8), chaque cellule mémoire correspondant dans cet exemple à un bit de données.

Dans cet exemple, chaque motif élémentaire correspond à une suite de k*l bits (8*8=64 bits dans l'exemple représenté) définissant, pour chaque cellule i parmi les k*l cellules de la matrice élémentaire prédéfinie, selon un sens de balayage prédéfini de la matrice élémentaire, par exemple ligne après ligne de bas en haut, et de gauche à droite dans chaque ligne, si la cellule fait partie ou non du motif élémentaire à transférer. La première cellule est par exemple en haut à gauche et la dernière cellule (k*l-ième cellule) est en bas à droite. Chaque bit à un premier état, par exemple un état bas, correspond à une cellule ne faisant pas partie du motif élémentaire à transférer, et chaque bit à un deuxième état, par exemple un état haut, correspond à une cellule faisant partie du motif élémentaire à transférer.

Sur la figure 9, plusieurs exemples de motifs élémentaires sont représentés, d'une part sous forme matricielle, et d'autre part sous la forme d'une suite de bits (représentée en système hexadécimal sur la figure).

Dans l'exemple de la figure 9, 16 motifs élémentaires prédéfinis distincts sont stockés dans le circuit d'accès direct 203. Les modes de réalisation décrits ne se limitent bien entendu pas à ce cas particulier.

Les motifs élémentaires prédéfinis peuvent être stockés une fois pour toutes dans le circuit d'accès direct 203 à la conception du système. A titre de variante, les motifs élémentaires peuvent être mis à jour au moyen d'une instruction dédiée de commande du circuit d'accès direct 203. A titre d'exemple, les motifs élémentaires sont stockés dans une mémoire spécifique du circuit d'accès direct 203, cette mémoire spécifique étant mappée de façon à être directement accessible en écriture par le processeur du système.

Lorsque le circuit d'accès direct 203 reçoit une instruction de transfert ou de copie du type décrit en relation avec la figure 7, (READ_TRANSFER, WRITE_TRANSFER, COPY), l'instruction contient, dans le sous-champ (Pattern), un code, par exemple sur 4 bits dans l'exemple considéré en figure 9, identifiant l'un parmi la pluralité de motifs élémentaires prédéfinis stockés dans le circuit d'accès direct 203.

Une fois l'instruction décodée, le motif élémentaire correspondant est sélectionné en fonction du code d'identification (Pattern) transmis, par exemple au moyen d'un multiplexeur (MUX).

A titre de variante, les k*l bits du motif élémentaire sont transmis directement dans le champ Pattern des paramètres de l'instruction READ_TRANSFER ou WRITE_TRANSFER ou COPY.

Le motif élémentaire sélectionné est transmis à un module générateur de motif (Pattern Engine) ou module d'application de motif, par exemple une machine à états finis, qui reçoit également en entrée l'adresse de la cellule de référence (représentée par un point noir sur la figure 9) du motif à transférer. Ce module, par exemple implémenté par le circuit de contrôle 305 et/ou le circuit de génération d'adresses 307 dans l'exemple d'implémentation de la figure 3, génère la séquence d'adresses source et la séquence d'adresses destination du motif à transférer ou plus exactement des itérations de motifs à transférer tels que défini dans les paramètres de l'opération de transfert initiée (READ, WRITE ou COPY). Les données sont ensuite transférées, selon cette séquence, par le circuit d'accès direct 203.

Dans cet exemple, le motif élémentaire est sélectionné dans une liste de plusieurs motifs élémentaires prédéfinis.

Lors de l'écriture dans la mémoire destination, les données peuvent être écrite réagencées selon un agencement prédéfini, par exemple selon une ou plusieurs lignes ou selon une ou plusieurs colonnes dans le cas où la mémoire destination est la mémoire CSRAM 201 et que les opérateurs de calculs sont respectivement reliés aux colonnes ou aux lignes de la mémoire CSRAM. Ceci permet par exemple de mettre en oeuvre des calculs parallélisés, par exemple de type SIMD, à partir des données de la mémoire destination. A titre d'exemple, chaque itération du motif élémentaire dans la mémoire source correspond à un vecteur ligne ou un vecteur colonne dans la mémoire destination, de façon similaire à ce qui a été décrit en relation avec la figure 5 ou en relation avec la figure 8.

On notera que les données transférées dans la mémoire de destination, dans le cas d'une opération WRITE, n'ont pas besoin d'être agencés selon une ou plusieurs lignes ou colonnes dans la mémoire externe de la manière décrite précédemment si on ne souhaite pas réaliser de calcul de type SIMD dans cette mémoire de destination. Les données dans la mémoire de destination sont néanmoins de préférence rangées selon une organisation « row major » pour faciliter les éventuelles opérations subséquentes d'accès à ces données.

Parmi les applications pouvant bénéficier des mécanismes de transfert et de réagencement de données décrits ci-dessus, on peut citer, à titre d'exemples non limitatifs, des manipulations de matrices, des manipulations de données selon des codes Stencil, des calculs de convolution, des réseaux de neuronaux convolutifs, etc. A chaque fois, une séquence de plusieurs itérations d'un motif élémentaire quelconque (croix, ligne, colonne, matrice, etc.) est transférée de la mémoire source vers la mémoire destination, en réagençant chaque itération du motif selon un vecteur ligne ou un vecteur colonne dans la mémoire destination en vue de réaliser des opérations de calcul parallélisées dans la mémoire destination.

On a décrit ci-dessus la mise en oeuvre d'un jeu d'instructions spécifiques permettant de commander un circuit d'accès direct étroitement couplé à un circuit mémoire adapté à mettre en oeuvre des opérations de calcul. Ceci constitue une amélioration du système décrit dans la demande de brevet français N° FR2014174 déposée par le demandeur le 28 décembre 2020 et intitulée "Module mémoire adapté à mettre en oeuvre des fonctions de calcul", dans lequel des écritures multiples dans des registres de configuration sont requises pour configurer le circuit d'accès direct.

Plus généralement, les modes de réalisation décrits peuvent être appliqués dans tout type de circuit d'accès direct (DMA), non nécessairement étroitement couplé à une mémoire adaptée à mettre en oeuvre des opérations de calcul, par exemple dans un système du type décrit ci-après en relation avec la figure 10.

La figure 10 représente schématiquement un exemple d'un système de transfert de données selon un mode de réalisation.

Le système de la figure 10 comprend deux circuits mémoire MEM1 et MEM2, un processeur CPU, un circuit d'accès direct dit "intelligent" SDMA, et un bus 401. Dans cet exemple, les circuits mémoires MEM1 et MEM2, le processeur CPU et le circuit d'accès direct SDMA sont tous reliés au bus 401. A titre d'exemple, au moins l'un des circuits mémoire MEM1 et MEM2 est adapté à mettre en oeuvre des fonctions de calcul. Les modes de réalisation décrits ne se limitent toutefois pas à ce cas particulier.

A titre d'exemple, le bus 401 peut comprendre un bus système mémoire (MSB), similaire au bus 251 (MSB) de l'exemple de la figure 2, et un bus de données processeur (CDB), similaire au bus 239 (CDB). Les circuits mémoire MEM1 et MEM2 et le circuit d'accès direct SDMA sont reliés au bus système mémoire (MSB) de façon à permettre au circuit d'accès direct SDMA de commander des transferts directs de données entre les circuits MEM1 et MEM2, par l'intermédiaire du bus système mémoire (MSB).

A titre d'exemple, le circuit d'accès direct SDMA comprend un circuit interne de contrôle adapté à commander des transferts de données agencées selon des motifs complexes du type décrit ci-dessus, de la mémoire MEM1 vers la mémoire MEM2 ou inversement, avec un réagencement des données lors du transfert défini en fonction d'un motif élémentaire de transfert.

De façon similaire à ce qui a été décrit ci-dessus en relation avec la figure 9, un motif élémentaire est défini dans une matrice élémentaire de dimensions k*l, par exemple une matrice élémentaire de 8*8 cellules voisines. Plus particulièrement, le motif élémentaire est défini par une suite de k*l bits indiquant, pour chaque cellule de la matrice élémentaire, si le contenu de la cellule doit être transféré ou non. Ceci permet d'encoder aisément des motifs complexes adaptés à tous types d'application.

A titre d'exemple, le circuit d'accès direct SDMA comprend des registres de contrôle adaptés à recevoir les différents paramètres requis pour la mise en oeuvre des transferts. Les paramètres peuvent être écrits par le processeur dans les registres de contrôle par l'intermédiaire du bus 401, de préférence par l'intermédiaire du bus de données processeur (CDB) du bus 401.

Les différents paramètres de contrôle du circuit d'accès direct sont par exemple :

SRC_ADDR : l'adresse source de la cellule de référence de la première itération du motif élémentaire de la séquence à transférer (X pos, Y pos dans l'exemple de la figure 7). Ce paramètre est par exemple stocké dans un registre de contrôle dédié du circuit d'accès direct SDMA, par exemple un registre de 32 bits.

DST_ADDR : l'adresse destination de l'élément de base de la première itération du motif élémentaire de la séquence à transférer (IMC address dans l'exemple de la figure 7). Ce paramètre est par exemple stocké dans un registre de contrôle dédié du circuit d'accès direct SDMA, par exemple un registre de 32 bits.

BIT_PATTERN : la suite de k*l bits définissant le motif élémentaire de la séquence à transférer. Ce paramètre est par exemple stocké dans un ou plusieurs registres dédiés du circuit d'accès direct SDMA, par exemple dans deux registres de 32 bits chacun pour un motif élémentaire défini dans une matrice élémentaire de 8*8 éléments.

SEQ_LEN : la longueur de chaque séquence, c'est-à-dire le nombre d'itérations du motif élémentaire dans la séquence de données à transférer (Length dans l'exemple de la figure 7). Ce paramètre est par exemple stocké dans un registre dédié du circuit d'accès direct, par exemple un registre de 32 bits.

SEQ_OFF : un décalage supplémentaire appliqué dans la mémoire destination entre chaque transfert généré par le dispositif, afin de s'assurer que l'agencement des données dans la mémoire destination corresponde bien à celui désiré par l'utilisateur, notamment pour gérer des problématiques d'alignement. Par exemple, si l'on souhaite effectuer un transfert de 3 convolutions de 16 bits vers une mémoire destination 128-bit (8x16 -bit), la longueur de la séquence SEQ_LEN est égale à 3 et le décalage nécessaire entre chaque transfert est de 5 éléments, pour correctement aligner les données (correspondant par exemple au cas de la figure 8). Ce paramètre est par exemple stocké dans un registre dédié du circuit d'accès direct, par exemple un registre de 32 bits.

SRC_OFFSET : le décalage des adresses sources (i.e. en lecture) entre deux itérations successives du motif élémentaire de la séquence (Src Off. dans l'exemple de la figure 7). Ce paramètre est par exemple stocké dans un registre dédié du circuit d'accès direct, par exemple un registre de 32 bits.

DST_OFFSET : le décalage des adresses destination (i.e. en écriture) entre deux itérations successives du motif élémentaire de la séquence (Dst off. dans l'exemple de la figure 7). Ce paramètre est par exemple stocké dans un registre dédié du circuit d'accès direct, par exemple un registre de 32 bits.

EL_SIZE : la taille de chaque élément du motif BIT_PATTERN. Ce paramètre est par exemple stocké dans un registre dédié du circuit d'accès direct, par exemple un registre de 32 bits. ARR_WIDTH : la largeur de la sous-région de la mémoire source dans laquelle se situe la séquence à transférer (utilisée pour générer les adresses à partir de l'adresse de base SRC_ADDR - correspondant au paramètre R_WIDTH dans l'exemple de la figure 7). Ce paramètre est par exemple stocké dans un registre dédié du circuit d'accès direct, par exemple un registre de 32 bits.

TRANSFER_START : un drapeau de déclenchement du transfert par le circuit d'accès direct SDMA. Ce paramètre est par exemple stocké dans un registre dédié du circuit d'accès direct, par exemple un registre de 32 bits.

TRANSFER_DONE : un paramètre mis à un premier état, par exemple la valeur 1, lorsque le transfert est terminé, et à un deuxième état, par exemple la valeur 0, tant que le transfert n'est pas terminé. Ce paramètre est par exemple stocké dans un registre dédié du circuit d'accès direct, par exemple un registre de 32 bits.

Des optimisations de stockage des paramètres peuvent être mises en oeuvre afin de réduire le nombre de registres de configuration requis.

A titre de variante, les paramètres de transfert peuvent être transmis au circuit d'accès direct SDMA au moyen d'un jeu d'instructions spécifique, par exemple du type décrit en relation avec la figure 7.

A titre d'exemple, lors de l'exécution d'un transfert, la matrice élémentaire définissant un motif élémentaire à transférer est balayée selon un sens prédéfini, par exemple ligne par ligne de haut en bas, et de gauche à droite dans chaque ligne.

Pour chaque élément de la matrice élémentaire, si le bit correspondant du paramètre BIT_PATTERN est à un premier état, par exemple un état bas, rien ne se passe.

Si en revanche le bit correspondant du paramètre BIT_PATTERN est à un deuxième état, par exemple un état haut, un transfert est généré. A titre d'exemple, dans ce cas un ensemble de SEQ_LEN éléments (nombre d'itérations de motifs) séparés deux à deux par SRC_OFFSET éléments est lu dans la mémoire source. Les SEQ_LEN éléments sont ensuite écrits dans la mémoire destination, séparés deux à deux par DST_OFFSET éléments. Autrement dit, pour chaque bit à l'état haut du paramètre BIT_PATTERN, on transfère simultanément ou successivement SEQ_LEN éléments de même position dans les SEQ_LEN itérations du motif élémentaire de la séquence à transférer, avant de continuer le balayage du motif élémentaire. Pour chaque itération du motif élémentaire, l'adresse de l'élément courant à transférer est déterminée par le circuit d'accès direct à partir de l'adresse de la cellule de référence de l'itération concernée (elle-même déterminée à partir de l'adresse de la cellule de référence de la première itération du motif, transmise via le champ SRC_ADDR (ou via les champ X Pos, Y Pos)), et des indices de ligne et de colonne de l'élément dans la matrice élémentaire dans laquelle est défini le motif élémentaire.

A titre de variante, dans le cas d'un recouvrement ou chevauchement des différentes itérations du motif élémentaire de la séquence à transférer, le circuit de contrôle interne peut avantageusement être configuré pour anticiper les données redondantes et ainsi réduire les accès en lecture à la mémoire source. Dans ce cas, pour chaque élément de la mémoire source, le circuit d'accès direct SDMA détermine si l'élément appartient à plusieurs itérations du motif élémentaire dans la séquence de données à transférer. Si l'élément doit être écrit plusieurs fois, il est, après sa première lecture dans la mémoire destination, stocké dans une mémoire interne du circuit d'accès direct SDMA. Ainsi, le circuit d'accès direct SDMA peut réécrire successivement plusieurs fois l'élément sans avoir besoin d'accéder à la mémoire source. Une autre possibilité consiste à lancer une lecture dans la mémoire destination à l'adresse contenant la donnée déjà transférée pour la « récupérer » et la copier, l'écrire, dans l'adresse de destination concernée.

Si l'on désigne par S l'ensemble des éléments du motif élémentaire à transférer (c'est-à-dire le sous ensemble des éléments de la matrice élémentaire de k*l éléments pour lesquels le bit correspondant du motif BIT_PATTERN est à l'état '1'), la dimension size_of(S) du sous-ensemble S (avec size_of(S) <= k*l) définit le nombre d'éléments à transférer du motif élémentaire, aussi appelé nombre d'occurrences.

Le transfert des données de la mémoire source MEM1 vers la mémoire destination MEM2 peut être exécuté selon une routine définie en langage de programmation, par exemple en langage C, ou en pseudo-langage de programmation, comme suit :

```
for i in [0..size_of(S)-1]:
for j in [0 .. SEQ_LEN]
DST_{i,j}=MEM2[DST_ADDR+EL_SIZE*(i*SEQ_LEN+SEQ_OFF)+DST_OFFSET*j
]
SRC_{i,j}=MEM1[SRC_ADDR+EL_SIZE*(S[i].x*ARR_WIDTH+S[i].y+SRC_OFF
SET*j]
MEMCPY(DST_{i,j},SRC_{i,j})
end for
end for
```

Les paramètres $S[i].x$ et $S[i].y$ définissent ici respectivement l'indice de ligne et l'indice de colonne du ième élément de l'ensemble S dans la matrice élémentaire dans laquelle est défini le noyau de calcul BIT_PATTERN.

La figure 11 illustre schématiquement le balayage d'une matrice de données de dimensions M*N (par exemple la matrice A de la figure 6) et la sélection des emplacements de la matrice A à lire au moyen du noyau de calcul ou BIT_PATTERN. Les données de la matrice A sont stockées dans une sous-région du circuit mémoire source comprenant une suite d'emplacements consécutifs en termes d'adressage, contenant les éléments de la matrice. On a désigné sur la figure 11 par la référence ME, la matrice élémentaire de taille prédéfinie k*l, inférieure à la taille de la matrice A, dans laquelle est défini le motif élémentaire de données à transférer au moyen du noyau de calcul BIT_PATTERN. La matrice ME permet d'identifier une fenêtre matricielle élémentaire de la matrice A. Le circuit d'accès direct SDMA reçoit une adresse source pour un premier motif à transférer, cette adresse source correspondant à l'adresse, dans la sous-région (matrice A), de l'élément de référence $S_R$ du BIT_PATTERN et correspondant à une donnée de référence de la matrice de données située à cette adresse source. Les autres éléments du BIT_PATTERN sont associés à d'autres données de la matrice de données A par positionnement relatif par rapport respectivement à l'élément de référence du BIT_PATTERN et à la donnée de référence de ladite matrice (indices $S[i].x$ et $S[i].y$). Le circuit d'accès direct est adapté, lors de l'exécution du transfert d'un motif élémentaire, à récupérer les données de ladite matrice associées à des éléments du BIT_PATTERN dont le bit est à l'état '1'.

De façon optionnelle, le système de la figure 10 peut comprendre au moins un troisième circuit mémoire MEM3, le circuit d'accès direct étant adapté à commander des transferts de données indifféremment de l'un quelconque des circuits MEM1, MEM2 et MEM3 vers un autre des circuits MEM1, MEM2 et MEM3 ou vers le même circuit (COPY), selon les mécanismes décrits ci-dessus.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, on a décrit ci-dessus deux aspects principaux d'un système d'accès direct de données entre des première et deuxième mémoires.

Selon un premier aspect, on définit une sous-région d'intérêt dans la première mémoire et/ou dans la deuxième mémoire, au moyen d'une instruction spécifique de commande du circuit d'accès direct, puis on commande des transferts de données de la première mémoire vers la deuxième mémoire ou inversement, en transmettant au circuit d'accès direct uniquement des adresses source et/ou destination relatives, c'est-à-dire définies à l'intérieur de la sous-région d'intérêt.

Selon un deuxième aspect, le circuit d'accès direct est adapté à transférer une séquence de données comportant plusieurs itérations d'un motif élémentaire dont la forme est définie par une suite de bits BIT_PATTERN définissant, pour chaque cellule d'une fenêtre matricielle élémentaire prédéfinie, si la cellule fait partie ou non du motif élémentaire à transférer.

Ces deux aspects permettent de compresser les paramètres à transmettre au circuit d'accès direct pour commander un transfert de données de la première mémoire vers la deuxième mémoire, et ainsi de limiter les échanges entre le processeur et le circuit d'accès direct.

La personne du métier comprendra que ces deux aspects peuvent être mis en oeuvre indépendamment l'un de l'autre ou en combinaison selon les besoins de l'application considérée.

Par ailleurs, bien que ces deux aspects soient tout particulièrement avantageux dans le cas où l'une des deux mémoires du système est une mémoire adaptée à mettre en oeuvre des opérations de calcul, les modes de réalisation décrits ne se limitent pas à ce cas particulier et peuvent être appliqués à des systèmes comportant des circuits mémoire classiques, par exemple couplés à des unités de calcul externes.

Enfin, la mise en oeuvre pratique des modes de réalisation et variantes décrits est à la portée de la personne du métier à partir des indications fonctionnelles données ci-dessus.

**Revendications**

1. Système comportant :

   - un processeur (CPU) ;
   - un circuit (SDMA) de transfert direct d'une séquence de données entre un circuit mémoire source et un circuit mémoire destination sans passer par le processeur, une sous-région du circuit mémoire source comprenant une suite d'emplacements consécutifs en terme d'adressage contenant les éléments ($A_{x,y}$ ; $B_{x,y}$) d'une matrice de données (A ; B), dans lequel le circuit de transfert direct (SDMA) est adapté à recevoir et décoder une information de noyau de calcul dite BIT_PATTERN d'un motif élémentaire de données à transférer défini à partir d'une matrice élémentaire de k*l éléments binaires, avec k entier supérieur ou égal à 2 et l entier supérieur ou égal à 2, la taille de ladite matrice élémentaire étant inférieure à la taille de ladite matrice de données, la matrice élémentaire étant destinée à identifier une fenêtre matricielle élémentaire de ladite matrice, chaque élément de la matrice élémentaire comprenant un bit pouvant prendre un premier ou un deuxième état selon respectivement que l'élément n'appartient pas ou appartient audit motif, la matrice élémentaire du BIT_PATTERN comprenant un élément de référence (S) ; le circuit de transfert direct (SDMA) recevant une adresse source pour un premier motif à transférer, cette adresse source correspondant à l'adresse dans ladite sous-région dudit élément de référence du BIT_PATTERN et correspondant à une donnée de référence de ladite matrice de données située à cette adresse source, les autres éléments du BIT_PATTERN étant associés à d'autres données de ladite matrice par positionnement relatif par rapport respectivement à l'élément de référence du BIT_PATTERN et à la donnée de référence de ladite matrice ; le circuit de transfert direct étant adapté, lors de l'exécution du transfert d'un motif élémentaire, à récupérer les données de ladite matrice associées à des éléments du BIT_PATTERN dont le bit est audit deuxième état.

2. Système selon la revendication 1, dans lequel ledit circuit de transfert (SDMA) direct est adapté à parcourir ladite matrice élémentaire du BIT_PATTERN selon un sens prédéfini en considérant ainsi une suite d'éléments de la matrice élémentaire présentant ledit deuxième état et à transférer successivement les données de la matrice présentes dans le circuit mémoire source et respectivement associées à cette suite d'éléments.

3. Système selon l'une des revendications précédentes, dans lequel ledit circuit de transfert direct (SDMA) est adapté à écrire, dans le circuit mémoire destination, les données récupérées pour un motif élémentaire autour d'une donnée de référence en les ré-agençant selon un vecteur ligne ou colonne, et dans lequel le circuit mémoire destination est un circuit mémoire intelligent adapté à mettre en oeuvre des opérations de calcul et à réaliser des opérations élémentaires incluant une lecture ou une écriture de données dans le circuit mémoire ou un calcul à partir de données présentes dans le circuit mémoire.

4. Système selon l'une des revendications précédentes, dans lequel ladite sous-région est une suite d'emplacements consécutifs en terme d'adressage définis à partir d'une adresse de base BASE_ADDR contenant l'adresse d'une première cellule mémoire de la sous-région, chaque donnée de la matrice (A ; B) présentant une dimension définie par une paramètre EL_SIZE, la largeur des lignes de la matrice (A ; B) étant définie par un paramètre R_WIDTH ; l'adresse d'une donnée de la matrice étant définie par des coordonnées relatives Xpos et Ypos correspondant aux coordonnées, ligne et colonne, dans ladite matrice et à partir de ladite adresse de base BASE_ADDR, et dudit paramètre EL_SIZE, et dans lequel les données de la matrice sont rangées selon un sens de parcours prédéfini de la matrice.

5. Système selon les revendications 2 et 4, dans lequel les coordonnées S[i] .x, dans la direction des lignes, et S[i] .y, dans la direction des colonnes, d'un élément de ladite matrice élémentaire associée à un BIT_PATTERN sont définies par des indices positifs ou négatifs autour de coordonnées nulles associées audit élément de référence de la matrice élémentaire, les indices positifs ou négatifs d'une coordonnée d'un élément de la matrice élémentaire étant définis en fonction de ladite matrice de données et dudit sens de parcours prédéfini de ladite matrice élémentaire.

**6.** Système selon la revendication 5, dans lequel l'adresse Addr(Ax,y) d'une donnée de la matrice est définie selon la formule suivante :

$$Addr(Ax,y)=BASE\_ADDR+EL\_SIZE*(Xpos*R\_WIDTH+YPos),$$

et dans lequel l'adresse Addr(S[i]) d'une donnée de la matrice correspondant à un élément du BIT_PATTERN à transférer est définie selon la formule suivante :

$$Addr(S[i])=BASE\_ADDR+EL\_SIZE*(S[i].x*R\_WIDTH+S[i].y).$$

**7.** Système selon les revendications 2 et 3, dans lequel ladite séquence de données comprend plusieurs itérations de transfert d'un même motif élémentaire défini à partir d'un même BIT_PATTERN associé à ladite suite d'éléments de la matrice élémentaire, chaque itération de transfert visant à transférer des données situées respectivement dans plusieurs fenêtres matricielles élémentaires prédéfinies de mêmes dimensions du circuit mémoire source (MEM1) et décalées les unes par rapport aux autres, les décalages étant définis par une suite de décalages d'adresses à partir de l'adresse de la donnée source de la première fenêtre élémentaire ($S1_R$), et dans lequel le circuit de transfert direct (SDMA) est adapté, lors de l'exécution du transfert, à réaliser pour chaque élément de la suite d'éléments, une suite de lecture dans le circuit mémoire source des données correspondant à un même élément de la matrice élémentaire mais situées respectivement dans lesdites plusieurs fenêtres matricielles élémentaires, en définissant les adresses successives des données de cette suite à partir de l'adresse d'une première donnée correspondant à cet élément et associée à une première fenêtre matricielle élémentaire et de ladite suite de décalages et dans lequel le circuit de transfert est adapté à transférer les données desdites fenêtres matricielles élémentaires en les agençant respectivement selon des vecteurs colonne distincts dans le circuit mémoire destination (MEM2), une suite de données associées à un même élément de matrice élémentaire du BIT_PATTERN étant écrites dans des emplacement successifs en terme d'adressage de la mémoire destination dans une ou plusieurs lignes de la mémoire destination.

**8.** Système selon la revendication précédente, dans lequel le circuit de transfert direct est adapté à recevoir et décoder les paramètres de transfert suivants :

- SEQ_LEN : le nombre d'itérations du motif élémentaire dans la séquence de données à transférer ;
- SRC_OFFSET : le décalage des adresses sources entre deux itérations successives du motif élémentaire de la séquence de données à transférer ;
- DST_OFFSET : le décalage des adresses d'écriture, dans le circuit mémoire destination entre deux itérations successives du motif élémentaire de la séquence de données à transférer.

**9.** Système selon l'une quelconque des revendications 1 à 8, comportant au moins un premier (253 ; MEM1) et un deuxième (201 ; MEM2) circuits mémoire ; et

- le circuit (203 ; SDMA) de transfert direct étant adapté à transférer directement des données entre les premier (253 ; MEM1) et deuxième (201 ; MEM2) circuits mémoire, dans lequel le circuit de transfert direct (203 ; SDMA) est adapté à recevoir des instructions spécifiques en provenance d'un processeur externe (231 ; CPU), et à décoder lesdites instructions et commander en conséquence des transferts de données entre les premier (253 ; MEM1) et deuxième (201 ; MEM2) circuits,

dans lequel lesdites instructions spécifiques comprennent :

- une instruction spécifique SET_REGION de définition d'une sous-région dans le premier circuit mémoire (253 ; MEM1) vers ou depuis laquelle seront transférées les données ; et
- une instruction spécifique de transfert (READ_TRANSFER, WRITE_TRANSFER, COPY) entre ladite sous-région et le deuxième circuit mémoire (201 ; MEM2), l'instruction spécifique de transfert comprenant un premier champ d'adresses contenant les coordonnées relatives, dans ladite sous-région, d'une première cellule de référence ($S1_R$ ; @0),

et dans lequel le circuit de transfert direct (203 ; SDMA) est adapté à exécuter plusieurs instructions de transfert (READ_TRANSFER ; WRITE_TRANSFER ; COPY) successives vers ou depuis une même sous-région entre deux exécutions d'une instruction SET_REGION.

# Fig. 1

101(CSRAM)

103

107

SRAM_ARRAY

RS

113

FSM    I/O

109    111

N    103

105

M

107

# Fig. 2

251    239

235

IM

205

209

PC    CSRAM

200

201

CDB

237

CPU    AD    207

204

231    233    211

MSB

DIMA

203

241

255

MM

253

# Fig. 3

# Fig. 4

# Fig. 5

A(IN)

K

B(OUT)

n elements

Kernel    Kernel    Kernel    Kernel    } 9 elements

Window    Window    Window    ...    Window    } 9 elements

dot    dot    dot    dot

res    res    res    res

# Fig. 6

N

M

$$\begin{bmatrix} A_{0,0} & \cdots & A_{0,N-1} \\ \vdots & A_{x,y} & \vdots \\ A_{M-1,0} & \cdots & A_{M-1,N-1} \end{bmatrix}$$

@0    $A_{0,0}$

$\vdots$

$A_{0,N-1}$

$A_{1,0}$

$\vdots$

$A_{1,N-1}$

$\vdots$

@(MxN)-1    $A_{M-1,N-1}$

"row major"

# Fig. 7

| Opcode | Parameters | | | | | | |
|---|---|---|---|---|---|---|---|
| SET_REGION | BASE_ADDR | | EL_SI2E | | R_WIDTH | | |

| READ_TRANSFER | X pos | Y pos | IMC address | Src off. | Dst off. | Length | Pattern | Op. mode |
|---|---|---|---|---|---|---|---|---|

| COPY | IMC address 1 | IMC address 2 | Src off. | Dst off. | Length | Pattern | Op. mode |
|---|---|---|---|---|---|---|---|

| WRITE_TRANSFER | X pos | Y pos | IMC address | Dst off. | Src off. | Length | Pattern | Op. mode |
|---|---|---|---|---|---|---|---|---|

| BLOCKING_WAIT | |
|---|---|

# Fig. 8

# Fig. 9

{0x0000001C,
0x1C1C0000}

{0x00000000,
0x0F0F0F0F}

{0x00080808,
0x7F080808}

{0x00001C3E,
0x3E3E1C00}

Pattern

Source / dest
base addresses

| Pattern0 |
| Pattern1 |
| Pattern2 |
| Pattern3 |
| Pattern4 |
| Pattern5 |
| Pattern6 |
| Pattern7 |
| ... |
| Pattern15 |

64-bit

MUX

Pattern

Pattern
Engine

source / dest
addresses

EP 4 206 939 A1

# Fig. 10

# Fig. 11

Europäisches
Patentamt

European
Patent Office

Office européen
des brevets

# RAPPORT DE RECHERCHE EUROPEENNE

Numéro de la demande

**EP 22 21 4972**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2020/327079 A1 (ZHAO YAO [CN] ET AL) 15 octobre 2020 (2020-10-15) | 1,2,4-9 | INV. G06F12/02 |
| Y | * le document en entier * | 3 | G06F9/345 G06F15/78 |
| Y | EP 3 660 849 A1 (COMMISSARIAT ENERGIE ATOMIQUE [FR]) 3 juin 2020 (2020-06-03) * figure 8 bis * | 3 | G06T1/60 G11C7/10 |
| A | NIKOLA VUJIC ET AL: "DMA++: On the Fly Data Realignment for On-Chip Memories", IEEE TRANSACTIONS ON COMPUTERS, IEEE, USA, vol. 61, no. 2, 1 février 2012 (2012-02-01), pages 237-250, XP011391404, ISSN: 0018-9340, DOI: 10.1109/TC.2010.255 * figure 1 * | 1-9 | |

DOMAINES TECHNIQUES
RECHERCHES (IPC)

G06F
G06T
G11C

Le présent rapport a été établi pour toutes les revendications

| Lieu de la recherche | Date d'achèvement de la recherche | Examinateur |
|---|---|---|
| La Haye | 28 avril 2023 | Loiseau, Ludovic |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

...............................................................

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 22 21 4972

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-04-2023

| Document brevet cité au rapport de recherche | Date de publication | Membre(s) de la famille de brevet(s) | Date de publication |
|---|---|---|---|
| US 2020327079 A1 | 15-10-2020 | CN 108885596 A<br>US 2020327079 A1<br>WO 2019127517 A1 | 23-11-2018<br>15-10-2020<br>04-07-2019 |
| EP 3660849 A1 | 03-06-2020 | EP 3660849 A1<br>FR 3088767 A1<br>US 2020160905 A1 | 03-06-2020<br>22-05-2020<br>21-05-2020 |

EPO FORM P0460

Pour tout renseignement concernant cette annexe : voir Journal Officiel de l'Office européen des brevets, No.12/82

**EP 4 206 939 A1**

**RÉFÉRENCES CITÉES DANS LA DESCRIPTION**

**Documents brevets cités dans la description**

- EP 3252774 A
- EP 3503103 A
- FR 2008272
- FR 2014174